(19) Europäisches Patentamt
European Patent Office
Office européen des brevets

(11) **EP 3 589 963 B1**

(12) **EUROPÄISCHE PATENTSCHRIFT**

(45) Veröffentlichungstag und Bekanntmachung des Hinweises auf die Patenterteilung:
**23.11.2022 Patentblatt 2022/47**

(21) Anmeldenummer: **18711485.5**

(22) Anmeldetag: **22.02.2018**

(51) Internationale Patentklassifikation (IPC):
**G01R 27/26** (2006.01)     **G01R 31/64** (2020.01)
**G01R 15/06** (2006.01)

(52) Gemeinsame Patentklassifikation (CPC):
**G01R 27/2605; G01R 31/64;** G01R 15/06

(86) Internationale Anmeldenummer:
**PCT/EP2018/054412**

(87) Internationale Veröffentlichungsnummer:
**WO 2018/158138 (07.09.2018 Gazette 2018/36)**

(54) **VERFAHREN UND VORRICHTUNG ZUR ÜBERWACHUNG VON KONDENSATORDURCHFÜHRUNGEN FÜR EIN WECHSELSTROMNETZ**

METHOD AND DEVICE FOR MONITORING CAPACITOR BUSHINGS FOR AN ALTERNATING-CURRENT GRID

PROCÉDÉ ET DISPOSITIF DE SURVEILLANCE DE PASSAGES DE CONDENSATEUR POUR UN RÉSEAU À COURANT ALTERNATIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2017 DE 102017104109**

(43) Veröffentlichungstag der Anmeldung:
**08.01.2020 Patentblatt 2020/02**

(73) Patentinhaber: **Maschinenfabrik Reinhausen GmbH**
**93059 Regensburg (DE)**

(72) Erfinder:
• **VIERECK, Karsten**
**93049 Regensburg (DE)**
• **WU, Junliang**
**93055 Regensburg (DE)**
• **HERTEL, Udo**
**93055 Regensburg (DE)**

(56) Entgegenhaltungen:
**EP-A2- 0 747 715     WO-A1-2015/071253**
**WO-A2-01/69272     US-A- 4 757 263**

• **RENE SEEBERGER: "Capacitance and Dissipation Factor Measurements", IEEE ELECTRICAL INSULATION MAGAZINE, IEEE SERVICE CENTER, NEW YORK, NY, US, Bd. 2, Nr. 1, 1. Januar 1986 (1986-01-01), Seiten 27-36, XP011360491, ISSN: 0883-7554, DOI: 10.1109/MEI.1986.290561**

**Beschreibung**

Die Erfindung betrifft ein Verfahren und eine Vorrichtung zum Überwachen von Kondensatordurchführungen für ein Wechselstromnetz.

Im Folgenden entspricht eine Formulierung der Art »A ist an B angebunden« einer Formulierung der Art »A ist mit B verbunden«, umfasst eine Formulierung der Art »A ist mit B verbunden« die Bedeutungen »A ist direkt mit B elektrisch leitend verbunden« und »A ist indirekt, also über C, mit B elektrisch leitend verbunden«, und hat eine Formulierung der Art »A ist an B angeschlossen« die Bedeutung »A ist direkt mit B elektrisch leitend verbunden«.

Elektrische Geräte für Wechselstromnetze, wie beispielsweise Leistungstransformatoren und Drosseln, sind üblicherweise mithilfe von Kondensatordurchführungen an die Netzleitungen des Wechselstromnetzes angeschlossen. Es ist bekannt, dass diese Kondensatordurchführungen dadurch überwacht werden, dass ihre Kapazitäten und Verlustfaktoren im Betrieb überprüft werden. In der Praxis weichen die im Betrieb gemessenen Messwerte der Kapazitäten und Verlustfaktoren der zu überwachenden Kondensatordurchführungen häufig von denjenigen Messwerten ab, die in einer Werkprüfung kurz nach deren Herstellung ermittelt worden sind. Diese Abweichungen erschweren dann die Auswertung der für die Überwachung im Betrieb gemessenen Messwerte beziehungsweise deren Vergleich mit Grenzwerten oder Toleranzwerten.

Die Gründe für diese Abweichungen werden nun erläutert. Die Werkprüfung einer Kondensatordurchführung wird in der Regel bei dem Hersteller in einem relativ kleinen Ölkessel durchgeführt, während sie sich im Betrieb in einem viel größeren Ölbehälter befindet, beispielsweise in dem Öltank eines Leistungstransformators. Diese Änderung der Messumgebung verursacht bei demselben Prüfobjekt unterschiedliche Streukapazitäten und unterschiedliche Messwerte. Die Werkprüfung einer Kondensatordurchführung findet meistens bei Raumtemperatur statt, während sie im Betrieb einer wesentlich höheren Betriebstemperatur ausgesetzt ist, die bei mindestens 50°C liegt. Die temperaturabhängige Kenngröße, insbesondere der Verlustfaktor, ändert sich daher deutlich. Die Kondensatordurchführung wird in der Werkprüfung direkt nach Herstellung geprüft, während sie nach Einbau in das elektrische Gerät im Vorfeld durch betriebsbegleitende Stressfaktoren belastet werden kann. So beeinflusst beispielsweise eine auf der Außenhaut gebildete Fremdschicht den Messwert des Verlustfaktors maßgeblich.

DE 195 19 230 C1 beschreibt ein Überwachungsverfahren und eine Überwachungsanordnung für eine Kondensatordurchführung für hohe Spannungen, die zwischen ihren Kondensatoreinlagen einen Abgriff für eine Teilspannung aufweist. Bei diesem Verfahren ist vorgesehen, dass die Teilspannung einer Erfassungseinrichtung zugeführt wird, welche die Teilspannung auf eine Änderung überwacht, dass eine Änderungen der Teilspannung und eine Zeitinformation hierzu gespeichert werden, dass der zeitliche Abstand zwischen zumindest zwei Änderungen ermittelt wird, und dass ein der Häufigkeit der Teilspannungsänderung entsprechendes Fehlersignal erzeugt wird. Diese Vorrichtung umfasst eine Erfassungseinrichtung, in der die Teilspannung auf eine Änderung überwacht wird, einen Speicher, in dem eine Änderungen der Teilspannung und eine Zeitinformation hierzu hinterlegt werden, ein Rechenglied, mit dem der zeitliche Abstand zwischen zumindest zwei Änderungen ermittelt wird, und Mittel zum Erzeugen eines Fehlersignals, wobei ein der Häufigkeit der Teilspannungsänderung proportionales Fehlersignal erzeugt wird. Der Abgriff ist über eine Messdurchführung mittels einer Messleitung an die Erfassungseinrichtung geführt. Der Abgriff liefert eine Teilspannung, die ein Abbild der am Inneren der Kondensatordurchführung anliegenden Hochspannung entspricht.

Da sich bei diesem bekannten Überwachungsverfahren und dieser bekannten Überwachungsanordnung die an der Kondensatordurchführung anliegende Hochspannung auf die Messsignale auswirkt und stark schwanken kann, können die am Abgriff erfassten Messwerte stark schwanken. Somit ist eine zuverlässige Überwachung der Kondensatordurchführung nicht gewährleistet.

DE 100 37 432 A1 beschreibt ein Verfahren und eine Vorrichtung zur Überwachung einer mit einer elektrischen Betriebsspannung beaufschlagten Kondensatordurchführung, bei der durch eine elektrisch leitende Einlage ein Spannungsteiler gebildet ist. Bei diesem Verfahren ist vorgesehen, dass mit einem mit der Einlage verbundenen Messabgriff und mit Erdpotential mindestens ein Messwert einer elektrischen Messgröße erfasst und gespeichert wird, wobei nach Erfassung des mindestens einen Messwerts die Impedanz zwischen dem Messabgriff und dem Erdpotential verändert wird und mit dem Messabgriff und dem Erdpotential mindestens ein Signalwert eines sich dann bildenden Messsignals erfasst und gespeichert wird, wobei der zeitliche Abstand zwischen dem Zeitpunkt der Erfassung des einen Messwerts und dem Zeitpunkt der Erfassung des einen Signalwerts derart bemessen ist, dass mögliche Änderungen der Betriebsspannung zwischen den beiden Zeitpunkten vernachlässigbar sind, wobei anhand des Messwerts und des Signalwerts durch Quotientenbildung eine Kenngröße ermittelt wird, die mit einem vorgegebenen Sollwert verglichen wird, und wobei bei einem Abweichen der Kenngröße von dem vorgegebenen Sollwert ein einen Fehler der Kondensatordurchführung anzeigendes Meldesignal gebildet wird. Bei dieser Vorrichtung ist ein mit der Einlage verbundener Messabgriff vorgesehen, der mit einer Messeinrichtung zur Erfassung einer elektrischen Messgröße verbunden ist, wobei die zwischen dem Messabgriff und Erdpotential vorliegende Impedanz eine Impedanzanordnung enthält, der eine Schalteinrichtung zugeordnet ist. Die Impedanzanordnung weist eine Fest-Impedanz auf, die über eine Schalteinrichtung an den Messabgriff anschließbar und von dem Messabgriff trennbar ist. Die Schalteinrichtung ist mit einer Steuereinrichtung verbunden. Zur Überwachung der Kondensatordurchführung befindet sich die Impedanzanordnung zunächst in einem ersten Messzustand, bei dem die Schalteinrichtung geöffnet und die Fest-Impedanz nicht mit dem Messabgriff verbunden ist. In diesem ersten Messzustand wird zu einem ersten Zeitpunkt ein Messwert einer elektrischen Messgröße erfasst und in einem Speicher in der Messeinrichtung gespeichert. Diese Messgröße ist hier die am Messabgriff gegen Erdpotential anliegende elektrische Spannung. In diesem Messzustand der Impedanzanordnung wird die Impedanz durch die Parallelschaltung von der Kapazität und dem Innenwiderstand des Messgeräts gebildet. Die Impedanz in diesem Messzustand wird als unveränderte Impedanz bezeichnet. Nach Erfassung der Messgröße wird die Impedanzanordnung in einen zweiten Messzustand versetzt. Dazu wird die Steuereinrichtung durch die Schalteinrichtung gesteuert in den geschlossenen Zustand versetzt. Dadurch ist die Fest-Impedanz jetzt elektrisch leitend mit dem Messabgriff verbunden. Die Impedanz wird nun aus der Parallelschaltung der Kapazität, des Innenwiderstands der Messeinrichtung und der Fest-Impedanz gebildet. In diesem zweiten Messzustand wird nun zu einem zweiten Zeitpunkt mit der Messeinrichtung ein Signalwert eines sich bildenden Messsignals erfasst und ebenfalls gespeichert. Das Messsignal ist die am Messabgriff gegen Erdpotential anliegende elektrische Spannung. Die Impedanz in diesem zweiten Messzustand wird als veränderte Impedanz bezeichnet.

Da sich bei diesem bekannten Verfahren und dieser bekannten Vorrichtung die an der Kondensatordurchführung anliegende Betriebsspannung auf die Messsignale auswirkt und stark schwanken kann, können die am Messabgriff erfassten Messwerte stark schwanken. Somit ist eine zuverlässige Überwachung der Kondensatordurchführung nicht gewährleistet.

DE 36 01 934 C2 beschreibt eine permanent überwachte Kondensatordurchführungsanordnung bei Großtransformatoren in Drehstromnetzen. Diese Kondensatordurchführungsanordnung umfasst drei Kondensatordurchführungen, von denen jede aus einem Wickelkörper mit eingebetteten Kondensatorbelägen besteht. Diese Kondensatordurchführungsanordnung umfasst je einen Messanschluss, der mit dem letzten äußeren Kondensatorbelag verbunden ist. Diese Kondensatordurchführungsanordnung umfasst einen äußeren Flanschkapazität zwischen dem letzten äußeren Kondensatorbelag und dem geerdeten Flansch einer jeden Durchführung, Bei dieser Kondensatordurchführungsanordnung ist vorgesehen, dass die Messanschlüsse der drei Kondensatordurchführungen über je einen Abgleichkondensator zu einem künstlichen Sternpunkt verbunden sind, der auf Erdpotential einstellbar ist, wobei zwischen dem künstlichen Sternpunkt und dem Erdpotential eine Messeinrichtung angeordnet ist. Es ist vorgesehen, dass die Messeinrichtung mit einer Auslöseeinrichtung verbunden ist, die bei einer Kapazitätsänderung der Kondensatorbeläge die gesamte Anordnung abschaltet.

US 4 757 263 A beschreibt, dass zur Überwachung der Isoliereigenschaften von Hochspannungsdurchführungen Kapazitätswerte bestimmt werden.

WO 2015 071 253 A1 beschreibt ein Verfahren und eine Vorrichtung zur Überwachung von Kondensatordurchführungen für ein dreiphasiges Wechselstromnetz, wobei jede Kondensatordurchführung einen Leiter, der mit einer der Netzleitungen des Wechselstromnetzes verbunden ist, und einen elektrisch leitfähigen Belag aufweist, der den Leiter umgibt. Dieses Verfahren umfasst die Schritte, dass

- für jede Kondensatordurchführung eine Oberkapazität und eine Unterkapazität ermittelt werden;
- an jeder Kondensatordurchführung eine Messspannung erfasst und/oder gemessen wird, die zwischen dem jeweiligen Belag und einem Massepotenzial anliegt;
- für jede Kondensatordurchführung eine Istkapazität berechnet wird, die von der jeweiligen Messspannung, der jeweiligen Unterkapazität sowie von der Messspannung, der Unterkapazität und der Oberkapazität einer der anderen Kondensatordurchführungen abhängt;
- für jede Kondensatordurchführung die jeweilige Oberkapazität mit der jeweiligen Istkapazität verglichen wird;
- ein Überwachungssignal erzeugt wird, das von den Ergebnissen der Kapazitätsvergleiche abhängt.

Bei diesem bekannten Verfahren und dieser bekannten Vorrichtung werden die Oberkapazitäten der Kondensatordurchführungen sowie deren Istkapazitäten im Betrieb miteinander verglichen. Sollte sich eine Istkapazität verändern, kann auf eine Beschädigung der entsprechenden Kondensatordurchführung geschlossen werden.

Vor diesem Hintergrund schlägt die Erfindung die Gegenstände der unabhängigen Ansprüche vor. Vorteilhafte Ausführungsformen der Erfindung sind in den abhängigen Ansprüchen beschrieben.

Die Erfindung schlägt gemäß einem ersten Aspekt ein Verfahren zum Überwachen von Kondensatordurchführungen für ein Wechselstromnetz gemäß Anspruch 1 vor.

Bei einem dreiphasigen Wechselstromnetz ist der Begriff »benachbart« in Hinblick auf einen vorbestimmten Drehsinn des entsprechenden Zeigersystems definiert, beispielsweise derart, dass die zweite Phase B der ersten Phase A benachbart ist, die dritte Phase C der zweiten Phase B und die erste Phase A der dritten Phase C.

Die Erfindung schlägt gemäß einem zweiten Aspekt eine Vorrichtung zum Überwachen von Kondensatordurchführungen für ein Wechselstromnetz gemäß Anspruch 16 vor.

Die Erfindung ermöglicht eine bessere Überwachung der Kondensatordurchführungen. Denn der normierte Kennwert hängt im Vergleich zu dem späteren Kennwert deutlich schwächer von den Unterschieden zwischen der Messumgebung bei der Werkprüfung und der Messumgebung im Betrieb sowie von der jeweiligen Messumgebung im Betrieb ab.

Jede Kondensatordurchführung kann nach Bedarf auf beliebige Art und Weise ausgebildet sein und beispielsweise wenigstens einen zusätzlichen Belag aufweisen, der insbesondere zwischen dem einen Belag und dem Leiter angeordnet ist, so dass dieser eine Belag einen äußersten Belag darstellt.

Das Ermitteln eines Kennwerts kann nach Bedarf auf beliebige Art und Weise erfolgen, beispielsweise an wenigstens einer der Netzleitungen und/oder an wenigstens einem der Beläge und/oder durch Messen, vorzugsweise an einer unbeschädigten oder fehlerfreien Kondensatordurchführung, oder durch Entnahme aus einem Datenblatt der Kondensatordurchführung oder durch Setzen auf einen Erfahrungswert oder durch Übernahme von einem früheren Durchlauf des Verfahrens. Alternativ oder zusätzlich kann das Ermitteln wenigstens eines Kennwerts beispielsweise vor oder nach oder gleichzeitig mit dem Ermitteln wenigstens einer der anderen Kennwerte und/oder vor oder nach oder gleichzeitig mit dem Erfassen wenigstens einer Spannung erfolgen.

Eine Änderung ist beispielsweise dann unzulässig, wenn sie ein vorbestimmtes Maß oder Grenzwert oder Toleranzwert überschreitet.

Bei einer Ausführungsform der Erfindung ist spezifiziert, dass ein Überwachungssignal in Abhängigkeit von den Ergebnissen dieser Überprüfung erzeugt wird.

Vorzugsweise ist die Auswerteeinrichtung derart ausgebildet, dass sie dies ausführen kann.

Das Überwachungssignal kann nach Bedarf auf beliebige Art und Weise ausgebildet sein, beispielsweise als akustisches und/oder optisches und/oder elektronisches Signal.

Nach dem Erzeugen des Überwachungssignals erfolgt vorzugsweise ein neuer oder nächster oder weiterer Durchlauf des Verfahrens.

Bei einer Ausführungsform der Erfindung ist spezifiziert, dass

- für jede dieser Phasen

  • zu einem oder dem vorbestimmten späteren Zeitpunkt tn nach dem anfänglichen Zeitpunkt t0 für die Kenngröße ein entsprechender späterer Kennwert ermittelt wird;
  • das Ermitteln des normierten Kennwerts zusätzlich von dem jeweiligen späteren Kennwert und/oder von wenigstens einem der übrigen späteren Kennwerte abhängt.

Vorzugsweise ist die Auswerteeinrichtung derart ausgebildet, dass sie dies ausführen kann.

Erfindungsgemäß ist spezifiziert, dass

- für jede dieser Phasen

  • zu einem oder dem anfänglichen Zeitpunkt für eine Referenzspannung ein entsprechender anfänglicher Referenzspannungswert ermittelt wird;
  • das Ermitteln des normierten Kennwerts zusätzlich von dem jeweiligen anfänglichen Referenzspannungswert und/oder von wenigstens einem der übrigen anfänglichen Referenzspannungswerte abhängt.

Erfindungsgemäß ist die Auswerteeinrichtung derart ausgebildet, dass sie dies ausführen kann.

Bei einer Ausführungsform der Erfindung ist spezifiziert, dass jede Referenzspannung von der jeweiligen Netzspannung abhängt.

Bei einer Ausführungsform der Erfindung ist spezifiziert, dass

- jede Referenzspannung die jeweilige Netzspannung ist;
- für jede dieser Phasen

  • zu dem anfänglichen Zeitpunkt die Netzspannung erfasst und ein entsprechender anfänglicher Netzspannungswert ermittelt wird;
  • der anfängliche Netzspannungswert den jeweiligen anfänglichen Referenzspannungswert bildet.

Vorzugsweise ist die Auswerteeinrichtung derart ausgebildet, dass sie dies ausführen kann.

Bei einer Ausführungsform der Erfindung ist spezifiziert, dass

- der ersten Netzleitung eine erste Parallel-Kondensatordurchführung zugeordnet ist;
- der zweiten Netzleitung eine zweite Parallel-Kondensatordurchführung zugeordnet ist;

- der dritten Netzleitung eine dritte Parallel-Kondensatordurchführung zugeordnet ist;
- jede dieser Parallel-Kondensatordurchführungen umfasst:

  • einen Leiter, der mit der zugeordneten Netzleitung verbunden ist,
  • einen elektrisch leitfähigen Belag, der diesen Leiter umgibt;

- jede Referenzspannung eine Parallel-Belagspannung, die zwischen dem Belag und Massepotenzial der jeweiligen Parallel-Kondensatordurchführung anliegt, ist;
- für jede dieser Phasen

  • zu dem anfänglichen Zeitpunkt die Parallel-Belagspannung erfasst und ein entsprechender anfänglicher Parallel-Belagspannungswert ermittelt wird;
  • der anfängliche Parallel-Belagspannungswert den jeweiligen anfänglichen Referenzspannungswert bildet.

Vorzugsweise ist die Auswerteeinrichtung derart ausgebildet, dass sie dies ausführen kann.

Diese Parallel-Kondensatordurchführungen sind beispielsweise vorhanden, um zusätzlich zu einem ersten elektrischen Gerät, das über die drei Kondensatordurchführungen an die drei Phasen angeschlossen ist, ein zweites elektrisches Gerät, das hier auch als Parallel-Gerät bezeichnet wird, parallel zu dem ersten Gerät an die drei Phasen anzuschließen. Da die Parallel-Belagspannungswerte die anfänglichen Referenzspannungswerte bilden, kann auf die Erfassung der Netzspannungen verzichtet werden. Dies führt zu Kosteneinsparungen sowie erleichterter Wartung und Instandhaltung, da weniger Messgeräte eingesetzt werden müssen.

Bei einer Ausführungsform der Erfindung ist spezifiziert, dass für jede dieser Phasen die Referenzspannung eine Konstantspannung ist, für die ein entsprechender Konstantspannungswert vorbestimmt wird.

Vorzugsweise ist die Auswerteeinrichtung derart ausgebildet, dass sie dies ausführen kann.

Bei einer Ausführungsform der Erfindung ist spezifiziert, dass die Konstantspannungswerte gleich einem Nennspannungswert des Wechselstromnetzes sind.

Bei einer Ausführungsform der Erfindung ist spezifiziert, dass

- für jede dieser Phasen

  • zu einem oder dem anfänglichen Zeitpunkt eine Belagspannung, die zwischen dem jeweiligen Belag und Massepotenzial anliegt, erfasst und ein entsprechender anfänglicher Belagspannungswert ermittelt wird;
  • das Ermitteln des normierten Kennwerts zusätzlich von dem jeweiligen anfänglichen Belagspannungswert und/oder von wenigstens einem der übrigen anfänglichen Belagspannungswerte abhängt.

Vorzugsweise ist die Auswerteeinrichtung derart ausgebildet, dass sie dies ausführen kann.

Das Erfassen wenigstens einer Belagspannung kann nach Bedarf auf beliebige Art und Weise erfolgen, beispielsweise vor oder nach oder bevorzugt gleichzeitig mit dem Erfassen wenigstens einer der anderen Belagspannungen und/oder vor oder nach oder gleichzeitig mit dem Ermitteln wenigstens eines Kennwerts.

Bei einer Ausführungsform der Erfindung ist spezifiziert, dass

- eine Messeinrichtung an diese Beläge gekoppelt ist und für jede dieser Phasen eine Belagspannung erfassen kann, die zwischen dem jeweiligen Belag und Massepotenzial anliegt;
- für jede dieser Phasen

  • ein Außenkondensator von dem jeweiligen Belag und Massepotenzial oder einem elektrisch leitfähigen Flansch, der an der Außenfläche der jeweiligen Kondensatordurchführung befestigt ist und an Massepotenzial anliegt, gebildet ist;
  • ein Unterspannungskondensator durch eine Parallelschaltung gebildet ist, die die Messeinrichtung und den Außenkondensator umfasst;
  • zu einem oder dem anfänglichen Zeitpunkt für die Unterkapazität des Unterspannungskondensators ein entsprechender Unterkapazitätswert ermittelt wird;
  • das Ermitteln des normierten Kennwerts zusätzlich von dem jeweiligen Unterkapazitätswert und/oder von wenigstens einem der übrigen Unterkapazitätswerte abhängt.

Vorzugsweise ist die Auswerteeinrichtung derart ausgebildet, dass sie dies ausführen kann.

Die Unterkapazität für jede Kondensatordurchführung kann nach Bedarf auf beliebige Art und Weise definiert sein, beispielsweise als die Kapazität einer Parallelschaltung, die die Messeinrichtung und den Außenkondensator, der von dem jeweiligen äußersten Belag und Massepotenzial oder von dem jeweiligen äußersten Belag und dem elektrisch leitfähigen Flansch gebildet wird, aufweist. Üblicherweise liegen die Unterkapazitäten zwischen 1 und 5 μF, sie können aber auch nach Bedarf andere Werte haben und beispielsweise zwischen 0,1 μF und 50 μF oder zwischen 0,2 μF und 20 μF oder zwischen 0,5 μF und 10 μF liegen. Alternativ oder zusätzlich können jede dieser Unterkapazitäten und wenigstens eine der anderen Unterkapazitäten gleich oder ungleich sein. Beispielsweise können die Unterkapazitäten im Verhältnis 1:2:3 oder 1:2:4 oder 1:2:5 oder 1:3:5 oder 1:3:7 oder 1:3:9 oder 1:4:7 oder 1:4:9 zueinander stehen.

Das Ermitteln eines Unterkapazitätswerts kann nach Bedarf auf beliebige Art und Weise erfolgen, beispielsweise durch Messen, vorzugsweise an einer unbeschädigten oder fehlerfreien Kondensatordurchführung, oder durch Entnahme aus einem Datenblatt der Kondensatordurchführung oder durch Setzen auf einen Erfahrungswert oder durch Übernahme von einem früheren Durchlauf des Verfahrens. Alternativ oder zusätzlich kann das Ermitteln wenigstens eines Unterkapazitätswerts beispielsweise vor oder nach oder gleichzeitig mit dem Ermitteln wenigstens eines der anderen Unterkapazitätswerte und/oder vor oder nach oder gleichzeitig mit dem Ermitteln wenigstens eines Oberkapazitätswerts und/oder vor oder nach oder gleichzeitig mit dem Erfassen wenigstens einer Belagspannung erfolgen.

Bei einer Ausführungsform der Erfindung ist spezifiziert, dass

- für jede dieser Phasen

  • ein Oberspannungskondensator durch den jeweiligen Belag und Leiter gebildet ist;
  • die jeweilige Kenngröße die Oberkapazität des jeweiligen Oberspannungskondensators und der jeweilige Kennwert ein entsprechender Oberkapazitätswert ist.

Die Oberkapazität für jede Kondensatordurchführung kann nach Bedarf auf beliebige Art und Weise definiert sein, beispielsweise als die Kapazität eines Kondensators, der von dem jeweiligen Belag und dem jeweiligen Leiter gebildet wird und hier als Oberspannungskondensator bezeichnet wird. Üblicherweise liegen die Oberkapazitäten zwischen 200 und 600 pF.

Falls die Kondensatordurchführung wenigstens einen zusätzlichen Belag aufweist, dann kann die Oberkapazität beispielsweise auch als die Kapazität einer Reihenschaltung definiert sein, die Kondensatoren, die jeweils von zwei benachbarten Belägen gebildet werden, sowie einen Kondensator, der von dem innersten der zusätzlichen Beläge und dem Leiter gebildet wird, aufweist und hier ebenfalls als Oberspannungskondensator bezeichnet wird.

Vorzugsweise werden die Oberkapazitätswerte mit den zu dem späteren Zeitpunkt im Betrieb ermittelten normierten Oberkapazitätswerten verglichen. Sollte sich ein normierter Oberkapazitätswert ändern, kann auf eine Beschädigung der entsprechenden Kondensatordurchführung geschlossen werden.

Bei einer Ausführungsform der Erfindung ist spezifiziert, dass

- zu einem oder dem späteren Zeitpunkt tn für jede dieser Phasen

  • die Belagspannung, insbesondere mithilfe der Messeinrichtung, erfasst und ein entsprechender späterer Belagspannungswert ermittelt wird;

- der normierte Oberkapazitätswert der ersten Kondensatordurchführung (2a) gemäß folgender Formel berechnet wird:

$$C'_a(t_n) = B_a \cdot \frac{V_a(t_n) \cdot N_a \cdot K_a}{V_b(t_n) \cdot N_b \cdot \left(\dfrac{B_b}{C_b}+1\right) - V_a(t_n) \cdot N_a \cdot K_a}$$

mit

$$N_a = \frac{R_a(t_0)}{V_a(t_0)} \cdot \frac{C_a}{B_a + C_a}$$

worin Ka ein vorbestimmter konstanter oder variabler erster Korrekturwert ist; und/oder

- der normierte Oberkapazitätswert der zweiten Kondensatordurchführung (2b) gemäß folgender Formel berechnet wird:

$$C'_b(t_n) = B_b \cdot \frac{V_b(t_n) \cdot N_b \cdot K_b}{V_c(t_n) \cdot N_c \cdot \left(\frac{B_c}{C_c}+1\right) - V_b(t_n) \cdot N_b \cdot K_a}$$

mit

$$N_b = \frac{R_b(t_0)}{V_b(t_0)} \cdot \frac{C_b}{B_b + C_b}$$

worin Kb ein vorbestimmter konstanter oder variabler zweiter Korrekturwert ist; und/oder
- der normierte Oberkapazitätswert der dritten Kondensatordurchführung (2c) gemäß folgender Formel berechnet wird:

$$C'_c(t_n) = B_c \cdot \frac{V_c(t_n) \cdot N_c \cdot K_c}{V_a(t_n) \cdot N_a \cdot \left(\frac{B_a}{C_a}+1\right) - V_c(t_n) \cdot N_c \cdot K_c}$$

mit

$$N_c = \frac{R_c(t_0)}{V_c(t_0)} \cdot \frac{C_c}{B_c + C_c}$$

worin Kc ein vorbestimmter konstanter oder variabler dritter Korrekturwert ist;
- Ba, Bb und Bc der erste, zweite und dritte Unterkapazitätswert sind;
- Ca, Cb und Cc der erste, zweite und dritte Oberkapazitätswert sind;
- Ra(t0), Rb(t0) und Rc(t0) der erste, zweite und dritte anfängliche Referenzspannungswert sind;
- Va(tn), Vb(tn) und Vc(tn ) der erste, zweite und dritte spätere Belagspannungswert sind.

Vorzugsweise ist die Auswerteeinrichtung derart ausgebildet, dass sie dies ausführen kann.
Bei einer Ausführungsform der Erfindung ist spezifiziert, dass

- Ka = 1 gilt; oder
- Ka = Rb(tn)/Ra(tn) gilt, worin

  • Ra(tn) ein späterer erster Referenzspannungswert ist, der zu einem oder dem späteren Zeitpunkt tn für eine erste Referenzspannung, die der ersten Phase zugeordnet ist, ermittelt wird;
  • Rb(tn) ein späterer zweiter Referenzspannungswert ist, der zu diesem späteren Zeitpunkt tn für eine zweite Referenzspannung, die der zweiten, der ersten Phase benachbarten Phase zugeordnet ist, ermittelt wird; und/oder wobei

- Kb = 1 gilt; oder
- Kb = Rc(tn)/Rb(tn) gilt, worin

  • Rb(tn) ein späterer zweiter Referenzspannungswert ist, der zu einem oder dem späteren Zeitpunkt tn für eine zweite Referenzspannung, die der zweiten Phase zugeordnet ist, ermittelt wird;
  • Rc(tn) ein späterer dritter Referenzspannungswert ist, der zu diesem späteren Zeitpunkt tn für eine dritte Referenzspannung, die der dritten, der zweiten Phase benachbarten Phase zugeordnet ist, ermittelt wird; und/oder wobei

- Kc = 1 gilt; oder
- Kc = Ra(tn)/Rc(tn) gilt, worin

  • Rc(tn) ein späterer dritter Referenzspannungswert ist, der zu einem oder dem späteren Zeitpunkt tn für eine dritte Referenzspannung, die der dritten Phase zugeordnet ist, ermittelt wird;
  • Ra(tn) ein späterer erster Referenzspannungswert ist, der zu diesem späteren Zeitpunkt tn für eine erste Referenzspannung, die der ersten, der dritten Phase benachbarten Phase zugeordnet ist, ermittelt wird.

Vorzugsweise ist die Auswerteeinrichtung derart ausgebildet, dass sie dies ausführen kann.

Ein Korrekturwert, für den die zweite Alternative, also der Quotient aus zwei Netzspannungen gilt, ergibt oder ermöglicht eine automatische Korrektur und/oder automatische Kompensation von Asymmetrien und/oder Abweichungen zwischen diesen beiden Netzspannungen. Hierdurch kann eine noch genauere Berechnung des jeweiligen späteren normierten Oberkapazitätswerts erreicht werden.

Bei einer Ausführungsform der Erfindung ist spezifiziert, dass beim Überprüfen der jeweilige normierte Kennwert mit dem jeweiligen Kennwert verglichen wird.

Vorzugsweise ist die Auswerteeinrichtung derart ausgebildet, dass sie dies ausführen kann.

Bei einer Ausführungsform der Erfindung ist spezifiziert, dass

- Toleranzwerte CA > 0, CB > 0, CC > 0 für die Kennwertvergleiche bestimmt werden;
- falls die Kennwertvergleiche ergeben, dass

$$\left| C'_a(t_n) - C_a \right| \le C_A \text{ und } \left| C'_b(t_n) - C_b \right| \le C_B \text{ und } \left| C'_c(t_n) - C_c \right| \le C_C$$

gilt, dann ein Überwachungssignal erzeugt wird, das anzeigt, dass die Kondensatordurchführungen in ordnungsgemäßem Zustand sind.

Vorzugsweise ist die Auswerteeinrichtung derart ausgebildet, dass sie dies ausführen kann.

Somit werden nach dem Bestimmen der Toleranzwerte die Kennwertvergleiche in einem Prüfschritt ausgewertet, was hier auch als erste Auswertung bezeichnet wird, und ein von dem Ergebnis dieser ersten Auswertung abhängiges Überwachungssignal erzeugt.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% des jeweiligen Kennwerts Ca, Cb, Cc oder eines Mittelwerts der Kennwerte Ca, Cb, Cc entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein.

Bei einer Ausführungsform der Erfindung ist spezifiziert, dass andernfalls ein Überwachungssignal erzeugt wird, das anzeigt, dass zumindest eine dieser Kondensatordurchführung nicht in ordnungsgemäßem Zustand ist.

Vorzugsweise ist die Auswerteeinrichtung derart ausgebildet, dass sie dies ausführen kann.

Somit wird dieses Überwachungssignal erzeugt, falls die erste Auswertung ergibt, dass der geprüfte Fall nicht vorliegt.

Bei einer Ausführungsform der Erfindung ist spezifiziert, dass

- Toleranzwerte CA > 0, CB > 0, CC > 0 für die Kennwertvergleiche bestimmt werden;
- falls die Kennwertvergleiche ergeben, dass

$$C'_a(t_n) - C_a < -C_A \text{ und } C'_b(t_n) - C_b > C_B \text{ und } \left| C'_c(t_n) - C_c \right| \le C_C$$

gilt, dann ein Überwachungssignal erzeugt wird, das anzeigt, dass zumindest die zweite Kondensatordurchführung nicht in ordnungsgemäßem Zustand ist;
- falls die Kennwertvergleiche ergeben, dass

$$C'_b(t_n) - C_b < -C_B \text{ und } C'_c(t_n) - C_c > C_C \text{ und } \left| C'_a(t_n) - C_a \right| \le C_A$$

gilt, dann ein Überwachungssignal erzeugt wird, das anzeigt, dass zumindest die dritte Kondensatordurchführung nicht in ordnungsgemäßem Zustand ist;
- falls die Kennwertvergleiche ergeben, dass

$$C_c'(t_n) - C_c < -C_C \text{ und } C_a'(t_n) - C_a > C_A \text{ und } \left| C_b'(t_n) - C_b \right| \leq C_B$$

gilt, dann ein Überwachungssignal erzeugt wird, das anzeigt, dass zumindest die erste Kondensatordurchführung nicht in ordnungsgemäßem Zustand ist.

Vorzugsweise ist die Auswerteeinrichtung derart ausgebildet, dass sie dies ausführen kann.

Somit werden nach dem Bestimmen der Toleranzwerte die Kennwertvergleiche in vier Prüfschritten ausgewertet, was hier auch als zweite Auswertung bezeichnet wird, und ein von dem Ergebnis dieser zweiten Auswertung abhängiges Überwachungssignal erzeugt. Jeder dieser Prüfschritte kann nach Bedarf auf beliebige Art und Weise erfolgen, beispielsweise vor oder nach oder gleichzeitig mit wenigstens einem anderen Prüfschritt.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% des jeweiligen Kennwerts Ca, Cb, Cc oder eines Mittelwerts der Kennwerte Ca, Cb, Cc entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein. Falls schon einmal Toleranzwerte CA, CB, CC bestimmt worden sind, beispielsweise für die erste oder die weiter unten beschriebene dritte Auswertung, so können diese vorzugsweise auch für diese zweite Auswertung übernommen werden.

Bei einer Ausführungsform der Erfindung ist spezifiziert, dass andernfalls ein Überwachungssignal erzeugt wird, das anzeigt, dass zumindest zwei dieser Kondensatordurchführungen nicht in ordnungsgemäßem Zustand sind.

Vorzugsweise ist die Auswerteeinrichtung derart ausgebildet, dass sie dies ausführen kann.

Somit wird dieses Überwachungssignal erzeugt, falls die zweite Auswertung ergibt, dass die geprüften Fälle nicht vorliegen.

Bei einer Ausführungsform der Erfindung ist spezifiziert, dass

- Toleranzwerte CA > 0, CB > 0, CC > 0 für die Kennwertvergleiche bestimmt werden;
- falls die Kennwertvergleiche ergeben, dass

$$C_a'(t_n) - C_a > C_A \text{ und } C_b'(t_n) - C_b < -C_B \text{ und } \left| C_c'(t_n) - C_c \right| \leq C_C$$

gilt, dann ein Überwachungssignal erzeugt wird, das anzeigt, dass die erste und die dritte Kondensatordurchführung nicht in ordnungsgemäßem Zustand sind und einen gleichartigen Fehler haben;
- falls die Kennwertvergleiche ergeben, dass

$$C_b'(t_n) - C_b > C_B \text{ und } C_c'(t_n) - C_c < -C_C \text{ und } \left| C_a'(t_n) - C_a \right| \leq C_A$$

gilt, dann ein Überwachungssignal erzeugt wird, das anzeigt, dass die zweite und die erste Kondensatordurchführung nicht in ordnungsgemäßem Zustand sind und einen gleichartigen Fehler haben;
- falls die Kennwertvergleiche ergeben, dass

$$C_c'(t_n) - C_c > C_C \text{ und } C_a'(t_n) - C_a < -C_A \text{ und } \left| C_b'(t_n) - C_b \right| \leq C_B$$

gilt, dann ein Überwachungssignal erzeugt wird, das anzeigt, dass die dritte und die zweite Kondensatordurchführung nicht in ordnungsgemäßem Zustand sind und einen gleichartigen Fehler haben.

Vorzugsweise ist die Auswerteeinrichtung derart ausgebildet, dass sie dies ausführen kann.

Somit werden nach dem Bestimmen der Toleranzwerte die Kennwertvergleiche in drei Prüfschritten ausgewertet, was hier auch als dritte Auswertung bezeichnet wird, und ein von dem Ergebnis dieser dritten Auswertung abhängiges Überwachungssignal erzeugt. Jeder dieser Prüfschritte kann nach Bedarf auf beliebige Art und Weise erfolgen, beispielsweise vor oder nach oder gleichzeitig mit wenigstens einem der anderen Prüfschritte.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% des jeweiligen Kennwerts Ca, Cb, Cc oder eines Mittelwerts der Kennwerte Ca, Cb, Cc entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein. Falls schon einmal Toleranzwerte CA, CB, CC bestimmt worden sind, beispielsweise für die erste oder zweite Auswertung, so können diese vorzugsweise auch für diese zweite Auswertung übernommen werden.

Bei einer Ausführungsform der Erfindung ist spezifiziert, dass

- zu einem intermediären Zeitpunkt t1 vor dem Ermitteln des normierten Kennwerts, insbesondere zu einem oder dem anfänglichen Zeitpunkt,

  • für jede dieser Phasen die Referenzspannung erfasst und ein entsprechender intermediärer Referenzspannungswert ermittelt wird;
  • diese intermediären Referenzspannungswerte untereinander verglichen werden;
  • das Ermitteln der normierten Kennwerte erfolgt, falls diese Vergleiche ergeben, dass diese intermediären Referenzspannungswerte nicht mehr als ein vorbestimmtes

Maß voneinander abweichen.

Vorzugsweise ist die Auswerteeinrichtung derart ausgebildet, dass sie dies ausführen kann.

Dieses Vergleichen der Netzspannungen ermöglicht, dass ein Zeitpunkt bestimmt wird, zu dem die eigentliche Überwachung, nämlich insbesondere das Ermitteln und Überprüfen der normierten Kennwerte und das Erzeugen des Überwachungssignals, besonders vorteilhaft oder günstig ist, da sie dann nicht durch über das vorbestimmte Maß hinaus voneinander abweichende Netzspannungen erschwert, behindert oder gar unmöglich gemacht wird. Damit wird erreicht, dass unabhängig von Schwankungen oder gar Ausfall der Netzspannungen sowie von Messtoleranzen beim Erfassen der Spannungen eine bessere Aussage über den Zustand der Kondensatordurchführungen getroffen werden kann.

Das Erfassen wenigstens einer Netzspannung kann nach Bedarf auf beliebige Art und Weise erfolgen, beispielsweise vor oder nach oder bevorzugt gleichzeitig mit dem Erfassen wenigstens einer der anderen Netzspannungen und/oder nach oder gleichzeitig mit oder bevorzugt vor dem Ermitteln wenigstens einer Oberkapazität und/oder nach oder gleichzeitig mit oder bevorzugt vor dem Ermitteln wenigstens einer Unterkapazität und/oder nach oder gleichzeitig mit oder bevorzugt vor dem Erfassen wenigstens einer Belagspannung.

Bei einer Ausführungsform der Erfindung ist spezifiziert, dass

- diese Spannungsvergleiche derart erfolgen, dass

  • Toleranzwerte RAB > 0, RBC > 0, RCA > 0 als das jeweilige Maß bestimmt werden;
  • geprüft wird, ob

$$\left| R_a(t_1) - R_b(t_1) \right| \le R_{AB}$$

und

$$\left| R_b(t_1) - R_c(t_1) \right| \le R_{BC}$$

und

$$\left| R_c(t_1) - R_a(t_1) \right| \le R_{CA}$$

gilt;

  - Ra(t1) der intermediäre Referenzspannungswert der ersten Phase ist;
  - Rb(t1) der intermediäre Referenzspannungswert der zweiten Phase ist;
  - Rc(t1) der intermediäre Referenzspannungswert der dritten Phase ist.

Vorzugsweise ist die Auswerteeinrichtung derart ausgebildet, dass sie dies ausführen kann.

Jeder dieser Toleranzwerte UAB, UBC, UCA kann nach Bedarf auf beliebige Art und Weise bestimmt werden und beispielsweise auf einen Wert gesetzt werden, der 0,1 % oder 0,2% oder 0,5% oder 1% oder 2% oder 3% oder 4% oder 5% oder 7% oder 10% oder 15% oder 20% oder 25% oder 30% oder 40% oder 50% des Nennwertes der jeweiligen Netzspannung Uae, Ube, Uce entspricht. Jeder dieser Toleranzwerte und wenigstens einer der anderen Toleranzwerte können gleich oder ungleich sein.

Jeder dieser Korrekturwerte kann nach Bedarf beliebig gewählt sein. Falls für die Korrekturwerte beispielsweise jeweils die erste Alternative, also Ka = Kb = Kc = 1 gewählt wird, dann sollte vorzugsweise der Spannungsvergleich vor der eigentlichen Überwachung verwendet werden und dabei weiter bevorzugt jeder der Toleranzwerte UAB, UBC, UCA auf einen eher niedrigen Wert gesetzt werden sollte, der beispielsweise 0,1% oder 0,2% oder 0,5% oder 1% oder 2% oder 3% oder 4% oder 5% oder 7% oder 10% des Nennwertes der jeweiligen Netzspannung Uae, Ube, Uce entspricht. Falls für die Korrekturwerte beispielsweise jeweils die zweite Alternative, also Ka = Ub/Ua und Kb = Uc/Ub und Kc = Ua/Uc gewählt wird, dann kann nach Bedarf auf den Spannungsvergleich vor der eigentlichen Überwachung verzichtet werden oder der Spannungsvergleich vor der eigentlichen Überwachung erfolgen und dabei vorzugsweise jeder der Toleranzwerte UAB, UBC, UCA auf einen eher höheren Wert gesetzt werden, der beispielsweise 2% oder 3% oder 4% oder 5% oder 7% oder 10% oder 15% oder 20% oder 25% oder 30% oder 40% oder 50% des Nennwertes der jeweiligen Netzspannung Uae, Ube, Uce entspricht.

Bei einer Ausführungsform der Erfindung ist spezifiziert, dass bei diesen Spannungsvergleichen Effektivwerte und/oder Scheitelwerte und/oder Amplituden der Referenzspannungen als diese jeweiligen Referenzspannungswerte verwendet werden.

Vorzugsweise ist die Auswerteeinrichtung derart ausgebildet, dass sie dies ausführen kann.

Bei einer Ausführungsform der Erfindung ist spezifiziert, dass

- jede dieser Kenngrößen der Verlustfaktor der jeweiligen Kondensatordurchführung ist.

Bei einer Ausführungsform der vorgeschlagenen Vorrichtung ist spezifiziert, dass die Vorrichtung umfasst:

- einen ersten Spannungswandler, der mit der ersten Netzleitung verbunden werden kann;
- einen zweiten Spannungswandler, der mit der zweiten Netzleitung verbunden werden kann;
- einen dritten Spannungswandler, der mit der dritten Netzleitung verbunden werden kann;
- eine Auswerteeinrichtung, die an die Spannungswandler und die Messeinrichtung gekoppelt ist;
  wobei
- jeder dieser Spannungswandler für die jeweilige Phase die Netzspannung erfassen kann;
- jede Referenzspannung die jeweilige Netzspannung ist;
- die Auswerteeinrichtung derart ausgebildet ist, dass sie für jede dieser Phasen

  • zu dem anfänglichen Zeitpunkt t0 die Netzspannung mithilfe des jeweiligen Spannungswandlers erfassen und einen entsprechenden anfänglichen Netzspannungswert ermitteln kann;

- für jede dieser Phasen

  • der anfängliche Netzspannungswert den jeweiligen anfänglichen Referenzspannungswert bildet.

Bei einer Ausführungsform der vorgeschlagenen Vorrichtung ist spezifiziert, dass

- der ersten Netzleitung eine erste Parallel-Kondensatordurchführung zugeordnet ist;
- der zweiten Netzleitung eine zweite Parallel-Kondensatordurchführung zugeordnet ist;
- der dritten Netzleitung eine dritte Parallel-Kondensatordurchführung zugeordnet ist;
- jede dieser Parallel-Kondensatordurchführungen umfasst:

  • einen Leiter, der mit der zugeordneten Netzleitung verbunden ist,
  • einen elektrisch leitfähigen Belag, der diesen Leiter umgibt;

- die Vorrichtung umfasst:

  • einen ersten Parallel-Messadapter, der mit dem Belag der ersten Parallel-Kondensatordurchführung verbunden werden kann;
  • einen zweiten Parallel-Messadapter, der mit dem Belag der zweiten Parallel-Kondensatordurchführung verbunden werden kann;

- einen dritten Parallel-Messadapter, der mit dem Belag der dritten Parallel-Kondensatordurchführung verbunden werden kann;
- eine Messeinrichtung, die an die Parallel-Messadapter gekoppelt ist;

- die Messeinrichtung für jede dieser Phasen eine Parallel-Belagspannung, die zwischen dem jeweiligen Belag und Massepotenzial anliegt, mithilfe des jeweiligen Parallel-Messadapters erfassen kann;
- jede Referenzspannung die jeweilige Parallel-Belagspannung ist;
- die Auswerteeinrichtung derart ausgebildet ist, dass sie für jede dieser Phasen

- zu dem anfänglichen Zeitpunkt die Parallel-Belagspannung mithilfe der Messeinrichtung erfassen und einen entsprechenden anfänglichen Belagspannungswert ermitteln kann;

- für jede dieser Phasen

- der anfängliche Parallel-Belagspannungswert den jeweiligen anfänglichen Referenzspannungswert bildet.

Diese Parallel-Kondensatordurchführungen sind beispielsweise vorhanden, um zusätzlich zu einem ersten elektrischen Gerät, das über die drei Kondensatordurchführungen an die drei Phasen angeschlossen ist, ein zweites elektrisches Gerät, das hier auch als Parallel-Gerät bezeichnet wird, parallel zu dem ersten Gerät an die drei Phasen anzuschließen. Da die Parallel-Belagspannungswerte die anfänglichen Referenzspannungswerte bilden, kann auf die Spannungswandler zur Erfassung der Netzspannungen verzichtet werden. Dies führt zu Kosteneinsparungen sowie erleichterter Wartung und Instandhaltung, da keine Messgeräte zusätzlich zu den sowieso erforderlichen Messadaptern und Parallel-Messadaptern eingesetzt werden müssen.

Bei einer Ausführungsform der vorgeschlagenen Vorrichtung ist spezifiziert, dass die Vorrichtung umfasst:

- einen ersten Messadapter, der mit dem Belag der ersten Kondensatordurchführung verbunden werden kann;
- einen zweiten Messadapter, der mit dem Belag der zweiten Kondensatordurchführung verbunden werden kann;
- einen dritten Messadapter, der mit dem Belag der dritten Kondensatordurchführung verbunden werden kann;
- eine oder die Messeinrichtung, die an die Messadapter gekoppelt ist;
  wobei
- die Auswerteeinrichtung an die Messeinrichtung gekoppelt ist;
- die Messeinrichtung für jede dieser Phasen eine Belagspannung, die zwischen dem jeweiligen Belag und Massepotenzial anliegt, mithilfe des jeweiligen Messadapters erfassen kann;
- die Auswerteeinrichtung derart ausgebildet ist, dass sie für jede dieser Phasen

- zu einem oder dem anfänglichen Zeitpunkt die Belagspannung mithilfe der Messeinrichtung erfassen und einen entsprechenden anfänglichen Belagspannungswert ermitteln kann;

- für jede dieser Phasen

- das Ermitteln des normierten Kennwerts zusätzlich von dem jeweiligen anfänglichen Belagspannungswert und/oder von wenigstens einem der übrigen anfänglichen Belagspannungswerte abhängt.

Die vorgeschlagene Vorrichtung kann nach Bedarf auf beliebige Art und Weise ausgebildet sein und beispielsweise wenigstens eine weitere Messeinrichtung und/oder wenigstens einen weiteren Messadapter und/oder wenigstens einen weiteren Parallel-Messadapter und/oder wenigstens eine weitere Auswerteeinrichtung aufweisen. Es kann beispielsweise für jeden Messadapter eine eigene Messeinrichtung und/oder eine eigene Auswerteeinrichtung vorgesehen sein. Alternativ kann die Messeinrichtung als gemeinsame Messeinrichtung für wenigstens zwei oder für alle Messadapter und/oder für wenigstens zwei oder für alle Parallel-Messadapter ausgebildet sein.

Bei einer Ausführungsform der vorgeschlagenen Vorrichtung ist spezifiziert, dass

- für jede dieser Phasen

- ein Außenkondensator von dem jeweiligen äußersten Belag und Massepotenzial oder einem elektrisch leitfähigen Flansch, der an der Außenfläche der jeweiligen Kondensatordurchführung befestigt ist und an Massepotenzial anliegt, gebildet ist;
- ein Unterspannungskondensator durch eine Parallelschaltung gebildet ist, die die Messeinrichtung und den jeweiligen Außenkondensator umfasst;

- die Auswerteeinrichtung derart ausgebildet ist, dass sie für jede dieser Phasen

  • zu einem oder dem anfänglichen Zeitpunkt für die Unterkapazität des Unterspannungskondensators einen entsprechenden Unterkapazitätswert ermitteln kann;

- für jede dieser Phasen

  • das Ermitteln des normierten Kennwerts zusätzlich von dem jeweiligen Unterkapazitätswert und/oder von wenigstens einem der übrigen Unterkapazitätswerte abhängt.

Bei einer Ausführungsform der vorgeschlagenen Vorrichtung ist spezifiziert, dass

- die Auswerteeinrichtung derart ausgebildet ist, dass sie zu einem oder dem späteren Zeitpunkt tn für jede dieser Phasen

  • die Belagspannung, insbesondere mithilfe der Messeinrichtung, erfassen und einen entsprechenden späteren Belagspannungswert ermitteln kann;

- die Auswerteeinrichtung (8) derart ausgebildet ist, dass sie den normierten Oberkapazitätswert der ersten Kondensatordurchführung (2a) gemäß folgender Formel berechnet:

$$C_a'(t_n) = B_a \cdot \frac{V_a(t_n) \cdot N_a \cdot K_a}{V_b(t_n) \cdot N_b \cdot \left(\dfrac{B_b}{C_b} + 1\right) - V_a(t_n) \cdot N_a \cdot K_a}$$

mit

$$N_a = \frac{R_a(t_0)}{V_a(t_0)} \cdot \frac{C_a}{B_a + C_a}$$

worin Ka ein vorbestimmter konstanter oder variabler erster Korrekturwert ist; und/oder
- die Auswerteeinrichtung (8) derart ausgebildet ist, dass sie den normierten Oberkapazitätswert der zweiten Kondensatordurchführung (2b) gemäß folgender Formel berechnet:

$$C_b'(t_n) = B_b \cdot \frac{V_b(t_n) \cdot N_b \cdot K_b}{V_c(t_n) \cdot N_c \cdot \left(\dfrac{B_c}{C_c} + 1\right) - V_b(t_n) \cdot N_b \cdot K_a}$$

mit

$$N_b = \frac{R_b(t_0)}{V_b(t_0)} \cdot \frac{C_b}{B_b + C_b}$$

worin Kb ein vorbestimmter konstanter oder variabler zweiter Korrekturwert ist; und/oder
- die Auswerteeinrichtung (8) derart ausgebildet ist, dass sie den normierten Oberkapazitätswert der dritten Kondensatordurchführung (2c) gemäß folgender Formel berechnet:

$$C'_c(t_n) = B_c \cdot \frac{V_c(t_n) \cdot N_c \cdot K_c}{V_a(t_n) \cdot N_a \cdot \left(\frac{B_a}{C_a}+1\right) - V_c(t_n) \cdot N_c \cdot K_c}$$

mit

$$N_c = \frac{R_c(t_0)}{V_c(t_0)} \cdot \frac{C_c}{B_c + C_c}$$

worin Kc ein vorbestimmter konstanter oder variabler dritter Korrekturwert ist;
- Ba, Bb und Bc der erste, zweite und dritte Unterkapazitätswert sind;
- Ca, Cb und Cc der erste, zweite und dritte Oberkapazitätswert sind;
- Ra(t0), Rb(t0) und Rc(t0) der erste, zweite und dritte anfängliche Referenzspannungswert sind;
- Va(tn), Vb(tn) und Vc(tn ) der erste, zweite und dritte spätere Belagspannungswert sind.

Bei einer Ausführungsform der vorgeschlagenen Vorrichtung ist spezifiziert, dass jeder dieser Spannungswandler als kapazitiver Spannungswandler oder induktiver Spannungswandler oder resistiver Spannungswandler ausgebildet ist.

Jeder Spannungswandler kann nach Bedarf auf beliebige Art und Weise ausgebildet sein und/oder mittels unterschiedlicher geeigneter Prinzipien realisiert werden oder sein. Er kann beispielsweise induktiv und/oder kapazitiv und/oder resistiv aufgebaut sein und/oder induktive und/oder kapazitive und/oder resistive Komponenten und/oder Bauteile aufweisen. Bevorzugt kann er einen kapazitiven Spannungsteiler, der zwei Kondensatoren, die in Reihe geschaltet sind, aufweist, und zwei Spulen oder Wicklungen aufweisen, die als Transformator zur induktiven galvanischen Trennung geschaltet sind.

Die Auswerteeinrichtung kann nach Bedarf auf beliebige Art und Weise ausgebildet sein, beispielsweise als gemeinsame Auswerteeinrichtung für wenigstens zwei oder für alle Messeinrichtungen und/oder für wenigstens zwei oder für alle Spannungswandler. Alternativ oder zusätzlich kann sie beispielsweise eine Oberauswerteeinrichtung und für jede Phase eine eigene Unterauswerteeinrichtung aufweisen, die mit der zu der jeweiligen Phase gehörenden Messeinrichtung, dem zu der jeweiligen Phase gehörenden Spannungswandler und der Oberauswerteeinrichtung verbunden ist.

Bei einer Ausführungsform der vorgeschlagenen Vorrichtung ist spezifiziert, dass die Messeinrichtung wenigstens einen Messkondensator und/oder wenigstens eine Messspule umfasst.

Bei einer Ausführungsform der vorgeschlagenen Vorrichtung ist spezifiziert, dass

- die Messeinrichtung umfasst:

  • eine erste Messspule, die an den ersten Messadapter angeschlossen ist;
  • eine zweite Messspule, die an den zweiten Messadapter angeschlossen ist;
  • eine dritte Messspule, die an den dritten Messadapter angeschlossen ist;

- die Induktivitäten dieser drei Messspulen ungleich sein.

Bei einer Ausführungsform der vorgeschlagenen Vorrichtung ist spezifiziert, dass die drei Induktivitäten im Verhältnis 1:2:3 oder 1:2:4 oder 1:2:5 oder 1:3:5 oder 1:3:7 oder 1:3:9 oder 1:4:7 oder 1:4:9 zueinander stehen.

Bei einer Ausführungsform der vorgeschlagenen Vorrichtung ist spezifiziert, dass

- die Messeinrichtung umfasst:

  • einen ersten Messkondensator, der an den ersten Messadapter angeschlossen ist;
  • einen zweiten Messkondensator, der an den zweiten Messadapter angeschlossen ist;
  • einen dritten Messkondensator, der an den dritten Messadapter angeschlossen ist;

- die Kapazitäten dieser drei Messkondensatoren ungleich sein.

Bei einer Ausführungsform der vorgeschlagenen Vorrichtung ist spezifiziert, dass die drei Kapazitäten im Verhältnis 1:2:3 oder 1:2:4 oder 1:2:5 oder 1:3:5 oder 1:3:7 oder 1:3:9 oder 1:4:7 oder 1:4:9 zueinander stehen.

Die Kapazität wenigstens eines der Messkondensatoren ist vorzugsweise um ein Vielfaches größer als die Kapazität des jeweiligen Außenkondensators.

Üblicherweise liegen die Kapazitäten der Messkondensatoren zwischen 1 und 5 μF, sie können aber auch nach Bedarf andere Werte haben und beispielsweise zwischen 0,1 μF und 50 μF oder zwischen 0,2 μF und 20 μF oder zwischen 0,5 μF und 10 μF liegen.

Die Kapazitäten der Messkondensatoren können nach Bedarf auf beliebige Art und Weise gewählt sein. So können beispielsweise für den Fall, dass in jeder Phase ein Messadapter an einen eigenen Messkondensator, der nur ihm zugeordnet ist, angeschlossen ist und diese drei Messkondensatoren in einer gemeinsamen Messeinrichtung zusammengefasst oder auf drei eigene Messeinrichtungen, die den Messadaptern zugeordnet sind, verteilt sind, die Kapazitäten dieser drei Messkondensatoren gleich sein oder zwei dieser Kapazitäten gleich und ungleich der dritten Kapazität sein oder alle drei Kapazitäten ungleich sein. Dies gilt analog für die Messspulen und ihre Induktivitäten.

Mit jeder der vorgeschlagenen Vorrichtungen kann beispielhaft eines der vorgeschlagenen Verfahren durchgeführt werden. Jede der vorgeschlagenen Vorrichtungen kann beispielhaft derart ausgebildet sein oder dazu dienen oder dafür geeignet sein, dass sie eines der vorgeschlagenen Verfahren ausführt oder ausführen kann.

Die Erläuterungen zu einem der Aspekte der Erfindung, insbesondere zu einzelnen Merkmalen dieses Aspektes, gelten entsprechend auch analog für die anderen Aspekte der Erfindung.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen oder mit einzelnen Merkmalen anderer Ausführungsformen verbunden oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen.

Die Zeichnungen zeigen in

FIG. 1 eine erste Ausführungsform einer Vorrichtung zum Überwachen von Kondensatordurchführungen für ein dreiphasiges Wechselstromnetz;

FIG. 2 einen Teil der Vorrichtung der FIG. 1;

FIG. 3 eine Ersatzschaltung für die erste Kondensatordurchführung der FIG. 2 mit Unterspannungskondensator und Oberspannungskondensator;

FIG.4 ein Ablaufdiagramm einer Ausführungsform eines Verfahrens zum Überwachen für ein dreiphasiges Wechselstromnetz;

FIG. 5 eine zweite Ausführungsform der Vorrichtung.

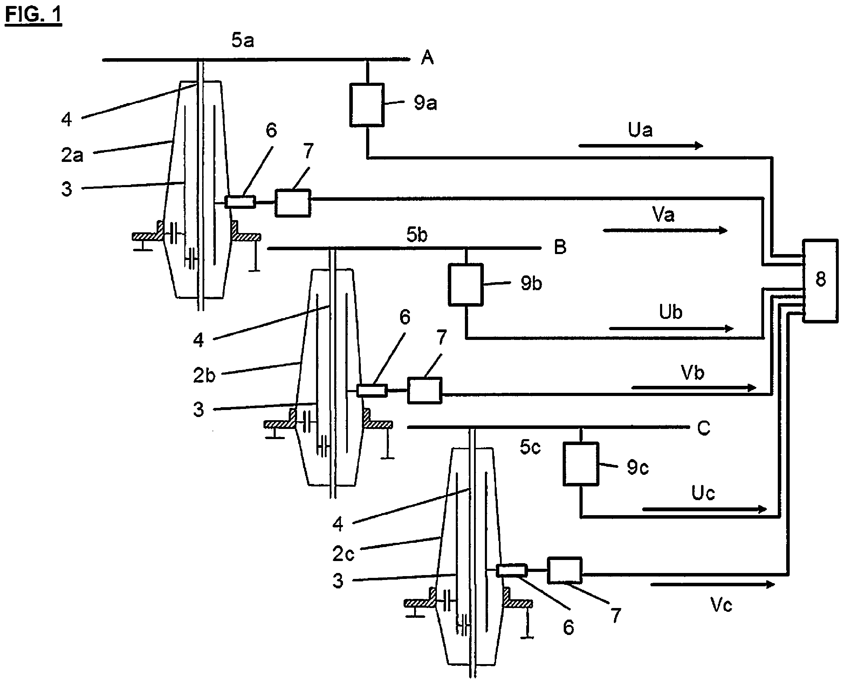

In FIG. 1 ist eine erste Ausführungsform einer Vorrichtung 1 zum Überwachen von Kondensatordurchführungen 2a, 2b, 2c für ein Wechselstromnetz, das beispielhaft drei Phasen A, B, C hat, schematisch dargestellt. Die Kondensatordurchführungen 2a, 2b, 2c gehören bei dieser Ausführungsform zu einem elektrischen Gerät (nicht dargestellt) für ein Wechselstromnetz, das hier beispielhaft ein Hochspannungstransformator ist. Derartige Kondensatordurchführungen 2a, 2b, 2c werden beispielsweise bei hohen Spannungen im Bereich von einigen wenigen kV bis zu einigen 1000 kV eingesetzt. Das Wechselstromnetz ist hier beispielhaft ein Hochspannungsnetz. Jede der drei Kondensatordurchführungen 2a, 2b, 2c ist einer der drei Phasen A, B, C des Wechselstromnetzes zugeordnet und weist einen Leiter 4, der mit der jeweiligen Netzleitung 5a, 5b, 5c des Wechselstromnetzes verbunden ist, und mehrere elektrisch leitfähige Beläge auf, die den Leiter 4 in mehreren Lagen oder Schichten umgeben und von denen lediglich der äußerste Belag 3 dargestellt ist.

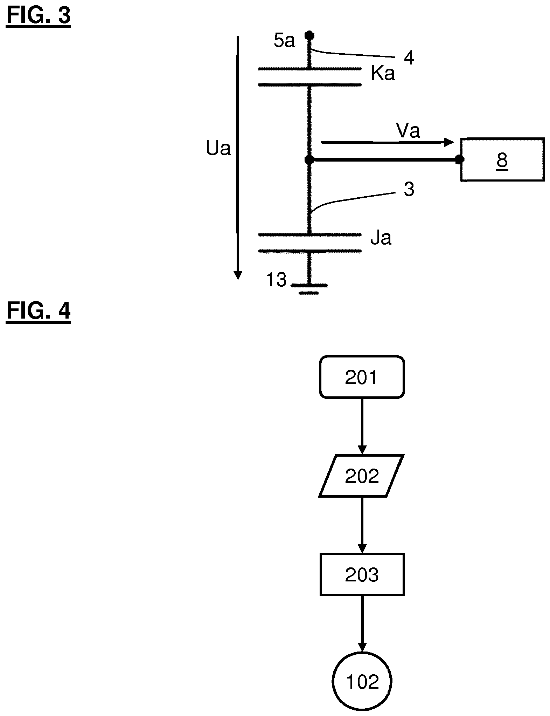

Die Vorrichtung 1 weist eine Auswerteeinrichtung 8 sowie für jede Phase A, B, C eine Messeinrichtung 7 und einen Messadapter 6 auf, der mit dem Belag 3 der zu der jeweiligen Phase A, B, C gehörenden Kondensatordurchführung 2a, 2b, 2c verbunden ist. Jeder Messadapter 6 ist mit der jeweiligen Messeinrichtung 7 verbunden, um eine erste elektrische Messgröße für die jeweilige Phase A, B, C zu erfassen. Diese ersten Messgrößen sind hier elektrische Spannungen, die jeweils an einem weiter unten beschriebenen und in FIG. 3 gezeigten Unterspannungskondensator Ja, Jb, Jc der jeweiligen Phase A, B, C anliegen und hier auch als Belagspannungen Va, Vb, Vc bezeichnet werden. Die Auswerteeinrichtung 8 ist mit jeder Messeinrichtung 7 verbunden, um die Belagspannungen Va, Vb, Vc an die Auswerteeinrichtung 8 zu übermitteln, und bildet somit eine gemeinsame Auswerteeinrichtung 8 für alle Messeinrichtungen 7.

Bei dieser Ausführungsform weist die Vorrichtung 1 zudem für jede Phase A, B, C einen Spannungswandler 9a, 9b, 9c auf, der mit der jeweiligen Netzleitung 5a, 5b, 5c verbunden ist, um eine zweite elektrische Messgröße für die jeweilige Phase A, B, C zu erfassen. Diese zweiten Messgrößen sind hier elektrische Spannungen, die jeweils an der jeweiligen Netzleitung 5a, 5b, 5c und Massepotenzial 13 anliegen und hier auch als Netzspannungen Ua, Ub, Uc bezeichnet werden. Die Auswerteeinrichtung 8 ist mit jedem Spannungswandler 9a, 9b, 9c verbunden, um die Netzspannungen Ua, Ub, Uc an die Auswerteeinrichtung 8 zu übermitteln, und bildet somit eine gemeinsame Auswerteeinrichtung 8 für alle Spannungswandler 9a, 9b, 9c.

Durch die Vorrichtung 1 wird die Möglichkeit geschaffen, dass die Auswerteeinrichtung 8 bei der Überwachung der Kondensatordurchführungen 2a, 2b, 2c Asymmetrien und/oder Schwankungen der Netzspannungen Ua, Ub, Uc auf den Netzleitungen 5a, 5b, 5c berücksichtigt.

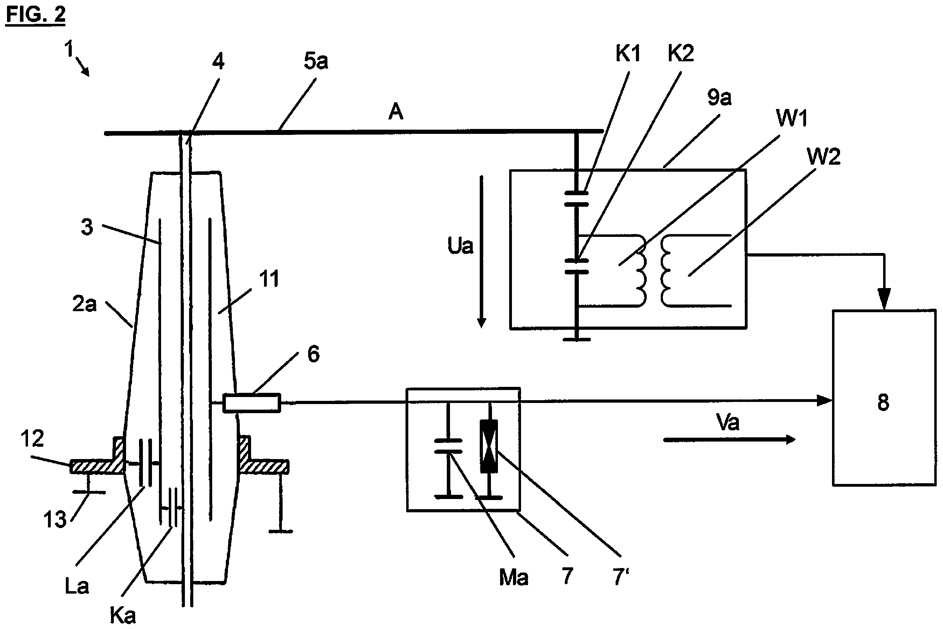

In FIG. 2 ist ein erster Teil der Vorrichtung 1 detaillierter dargestellt, der einer ersten Phase A zugeordnet ist. Diesem ersten Teil entsprechen analog ein einer zweiten Phase B zugeordneter zweiter Teil (nicht dargestellt) und ein einer dritten Phase C zugeordneter dritter Teil (nicht dargestellt) der Vorrichtung 1, sodass die Ausführungen und Erläuterungen zu dem ersten Teil entsprechend auch analog für diese beiden anderen Teile gelten.

Die erste Kondensatordurchführung 2a weist einen Isolationskörper 11 auf, durch dessen Inneres der Leiter 4 geführt ist. Dieser kontaktiert an seinem oberen Ende die zugeordnete erste Netzleitung 5a und an seinem unteren Ende eine hier Wicklung (nicht dargestellt) des Hochspannungstransformators. Im Isolierkörper 11 sind die elektrisch leitfähigen Beläge eingebettet, die hier nur durch den äußersten Belag 3 angedeutet sind und elektrisch gesehen eine Reihenschaltung von Kondensatoren bilden. Diese Reihenschaltung weist diejenigen Kondensatoren, die jeweils von zwei benachbarten Belägen gebildet werden, sowie einen Kondensator auf, der von dem hier nicht gezeigten innersten Belag und dem Leiter 4 gebildet wird. Diese Reihenschaltung von Kondensatoren zwischen dem äußersten Belag 3 und dem Leiter 4 bildet in einer Ersatzschaltung für jede Kondensatordurchführung 2a, 2b, 2c einen entsprechenden Oberspannungskondensator Ka, Kb, Kc mit einer Kapazität, die als Oberkapazität Ca, Cb, Cc bezeichnet wird.

An der Kondensatordurchführung 2a ist ein elektrisch leitfähiger Flansch 12 angeordnet, der am Erdpotenzial oder Massepotenzial 13 anliegt. Dieser Flansch 12 dient der Befestigung und/oder Sicherung der Kondensatordurchführung 2a. Der äußerste Belag 3 bildet mit dem Flansch 12 und Massepotenzial 13 in einer Ersatzschaltung für jede Kondensatordurchführung 2a, 2b, 2c einen entsprechenden Außenkondensator La, Lb, Lc mit der Kapazität.

Der Messadapter 6 dringt durch den Isolationskörper 11 hindurch und stellt eine elektrisch leitende Verbindung zum äußersten Belag 3 her. Er ist elektrisch leitend über die jeweilige Messeinrichtung 7 mit der Auswerteeinrichtung 8 verbunden, um die Belagspannung Va erfassen und an die Auswerteeinrichtung 8 übermitteln zu können. Bei dieser Ausführungsform weist jede Messeinrichtung 7 einen Messkondensator Ma, Mb, Mc auf, der auf Massepotenzial 13 geschaltet ist. Sie kann bei Bedarf zusätzlich eine nicht dargestellte Funkenstrecke, die parallel zu dem jeweiligen Messkondensator Ma, Mb, Mc geschaltet ist, und/oder einen Überspannungsschutz 7' aufweisen, der parallel zu dem jeweiligen Messkondensator Ma, Mb, Mc geschaltet ist.

Die Auswerteeinrichtung 8 ist über den ersten Spannungswandler 9a mit der Netzleitung 5a elektrisch leitend verbunden. Durch diese Verbindung wird die Spannung Ua erfasst, die zwischen der Netzleitung 5a und dem Massepotenzial 13 anliegt. Bei dieser Ausführungsform ist der Spannungswandler 9a als kapazitiver Spannungswandler ausgebildet und weist einen kapazitiven Spannungsteiler, der zwei in Reihe geschaltete Kondensatoren K1, K2 aufweist, und zwei Spulen oder Wicklungen W1, W2 auf, die als Transformator zur induktiven galvanischen Trennung geschaltet sind.

Diese Vorrichtung 1 ist geeignet und/oder kann derart ausgebildet sein, dass sie ein Verfahren zur Überwachung von Kondensatordurchführungen für ein dreiphasiges Wechselstromnetz ausführt. Ausführungsformen eines derartigen Verfahrens werden weiter unten beschrieben.

In FIG. 3 ist für die erste Phase A eine Ersatzschaltung aus dem jeweiligen, ersten Unterspannungskondensator Ja und dem jeweiligen, ersten Oberspannungskondensator Ka schematisch dargestellt. Eine Parallelschaltung, die den jeweiligen, ersten Messkondensator Ma und den jeweiligen, ersten Außenkondensator La aufweist, bildet den ersten Unterspannungskondensator Ja mit der ersten Unterkapazität Ba. Diese erste Unterkapazität Ba kann daher mit der bekannten Formel für die Reihenschaltung von Kondensatoren leicht aus der Kapazität des ersten Messkondensators Ma und der Kapazität des ersten Außenkondensators La berechnet werden. Bei Bedarf kann die Parallelschaltung anstelle des ersten Messkondensators Ma die gesamte jeweilige Messeinrichtung 7 und/oder zusätzlich die Auswerteeinrichtung 8 aufweisen, sodass dann die erste Unterkapazität Ba aus der Impedanz der Messeinrichtung 7, die von der Kapazität des ersten Messkondensators Ma abhängt, der Kapazität des ersten Außenkondensators La und der Impedanz der Auswerteeinrichtung 8 berechnet werden muss.

Die erste Belagspannung Va liegt wie oben erwähnt am ersten Unterspannungskondensator Ja an und wird an der Verbindungsleitung oder der Verbindungsstelle zwischen dem ersten Unterspannungskondensator Ja und dem ersten Oberspannungskondensator Ka abgegriffen und ist auf Massepotenzial 13 bezogen. Die erste Netzspannung Ua fällt über der Reihenschaltung aus dem ersten Oberspannungskondensator Ka und dem ersten Unterspannungskondensator Ja ab.

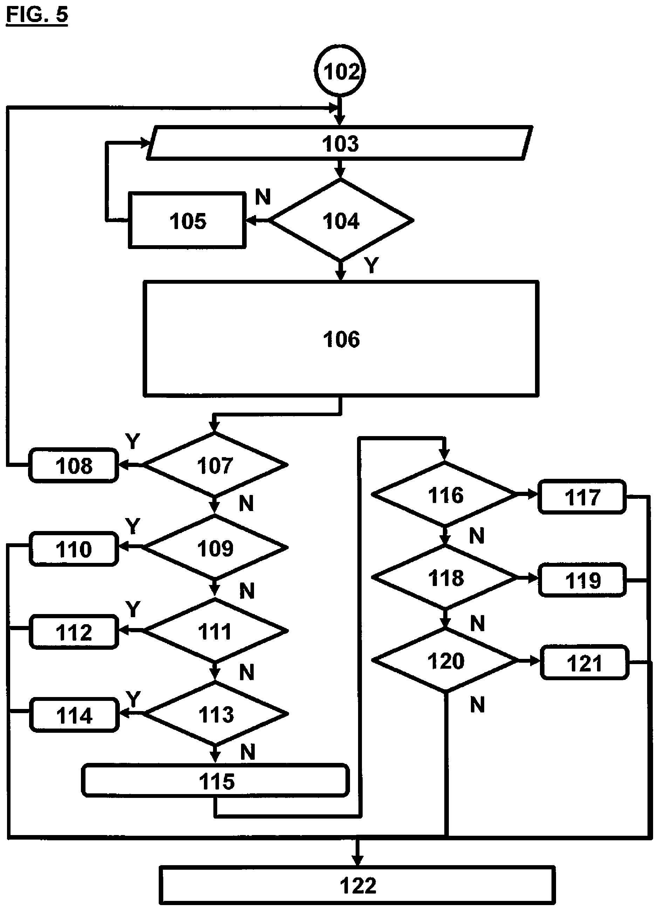

In FIG. 4 und FIG. 5 ist ein Ablaufdiagramm einer ersten Ausführungsform eines Verfahrens zum Überwachen von Kondensatordurchführungen 2a, 2b, 2c für ein Wechselstromnetz, das beispielhaft drei Phasen A, B, C hat, schematisch dargestellt. Dieses Verfahren kann beispielsweise durch die und/oder mithilfe der ersten Ausführungsform der Vorrichtung 1 der FIG. 1 ausgeführt werden.

Bei dieser Ausführungsform weist das Verfahren die folgenden Schritte auf, die unter Bezugnahme auf die Vorrichtung 1 und FIG. 1 und FIG. 2 erläutert werden:

Schritt 201 (FIG. 4): Start des Verfahrens.

Schritt 202: Dieser Schritt legt einen anfänglichen Zeitpunkt t0 fest. Für jede dieser Phasen A, B, C wird für die Oberkapazität ein entsprechender Oberkapazitätswert Ca, Cb, Cc und für die Unterkapazität ein entsprechender anfänglicher Unterkapazitätswert Ba, Bb, Bc durch die Auswerteeinrichtung 8 ermittelt. Für jede dieser Phasen A, B, C wird die Belagspannung mithilfe des jeweiligen Messadapters 6 und der jeweiligen Messeinrichtung 7 erfasst und ein entsprechender anfänglicher Belagspannungswert Va(t0), Vb(t0), Vc(t0) durch die Auswerteeinrichtung 8 ermittelt. Für jede dieser Phasen A, B, C wird die Netzspannung mithilfe des jeweiligen Spannungswandlers 9a, 9b, 9c erfasst und ein entsprechender anfänglicher Netzspannungswert Ua(t0), Ub(t0), Uc(t0) durch die Auswerteeinrichtung 8 ermittelt.

Bei dieser Ausführungsform sind diese Kapazitätswerte Ba, Bb, Bc, Ca, Cb, Cc als feste Werte in einem Speicher der Auswerteeinrichtung 8 hinterlegt und bilden diese Oberkapazitätswerte Ca, Cb, Cc die anfänglichen Kennwerte, diese Netzspannungen die Referenzspannungen und diese anfänglichen Netzspannungswerte Ua(t0), Ub(t0), Uc(t0) die anfänglichen Referenzspannungswerte Ra(t0), Rb(t0), Rc(t0).

Schritt 203: Für jede dieser Phasen A, B, C wird ein Normierungsfaktor Na, Nb, Nc gemäß folgenden Formeln durch die Auswerteeinrichtung 8 berechnet:

$$N_i = \frac{R_i(t_0)}{V_i(t_0)} \cdot \frac{C_i)}{B_i + C_i}$$

für i = a, b, c.

Anschließend erfolgt Sprung zu einem Schritt 102.

Schritt 102 (FIG. 5): Ziel für den Sprung von Schritt 204.

Schritt 103: Dieser Schritt legt einen intermediären Zeitpunkt t1 fest, der um eine vorbestimmte Zeitspanne nach dem anfänglichen Zeitpunkt t0 liegt. Für jede dieser Phasen A, B, C wird die Netzspannung mithilfe des jeweiligen Spannungswandlers 9a, 9b, 9c erfasst und ein entsprechender intermediärer Netzspannungswert Ua(t1), Ub(t1), Uc(t1) durch die Auswerteeinrichtung 8 ermittelt.

Schritt 104: Toleranzwerte RAB > 0, RBC > 0, RCA > 0 werden bestimmt. Die Effektivwerte der Netzspannungen werden als die jeweiligen intermediären Netzspannungswerte Ua(t1), Ub(t1), Uc(t1) verwendet.

Bei dieser Ausführungsform bilden diese intermediären Netzspannungen die intermediären Referenzspannungen und diese intermediären Netzspannungswerte Ua(t1), Ub(t1), Uc(t1) die intermediären Referenzspannungswerte Ra(t1), Rb(t1), Rc(t1).

Es wird in einem Spannungsvergleich geprüft, ob

$$\left| R_a(t_1) - R_b(t_1) \right| \le R_{AB}$$

und

$$\left| R_b(t_1) - R_c(t_1) \right| \le R_{BC}$$

und

$$\left| R_c(t_1) - R_a(t_1) \right| \le R_{CA}$$

gilt.

Falls ja, dann bedeutet dies, dass der Spannungsvergleich ergeben hat, dass die Netzspannungen nicht mehr als ein vorbestimmtes Maß voneinander abweichen. In diesem Fall wird ein Schritt 106 ausgeführt.

Falls nein, dann bedeutet dies, dass der Spannungsvergleich ergeben hat, dass die Netzspannungen mehr als ein vorbestimmtes Maß voneinander abweichen. In diesem Fall wird ein Schritt 105 ausgeführt.

Schritt 105: Ein Warnsignal wird erzeugt, das einen Kurzschluss im Wechselstromnetz und/oder eine zu starke oder übermäßige Asymmetrie der Netzspannungen anzeigt. Anschließend erfolgt Sprung zu Schritt 103.

Schritt 106: Dieser Schritt legt einen späteren Zeitpunkt tn fest, der um eine vorbestimmte Zeitspanne nach dem anfänglichen Zeitpunkt t0 und um eine vorbestimmte Zeitspanne nach dem intermediären Zeitpunkt t1 liegt. Für jede dieser Phasen A, B, C wird die Netzspannung mithilfe des jeweiligen Spannungswandlers 9a, 9b, 9c erfasst und ein entsprechender späterer Netzspannungswert Ua(tn), Ub(tn), Uc(tn) durch die Auswerteeinrichtung 8 ermittelt. Für jede dieser Phasen A, B, C wird die Belagspannung mithilfe des jeweiligen Messadapters 6 und der Messeinrichtung 7 erfasst und ein entsprechender späterer Belagspannungswert durch die Auswerteeinrichtung 8 ermittelt.

Bei dieser Ausführungsform bilden diese späteren Netzspannungswerte Ua(tn), Ub(tn), Uc(tn) die späteren Referenzspannungswerte Ra(tn), Rb(tn), Rc(tn).

Für jede dieser Phasen A, B, C wird ein variabler Korrekturwert Ka, Kb, Kc gemäß folgender Formel durch die Auswerteeinrichtung 8 berechnet:

$$K_i = \frac{R_j(t_n)}{R_i(t_n)}$$

für i = a, b, c und j = b, c, a.

Für jede dieser Phasen A, B, C wird ein normierter Oberkapazitätswert gemäß folgender Formel durch die Auswerteeinrichtung 8 berechnet:

$$C_i'(t_n) = B_i \cdot \frac{V_i(t_n) \cdot N_i \cdot K_i}{V_j(t_n) \cdot N_j \cdot \left(\frac{B_j}{C_j}+1\right) - V_i(t_n) \cdot N_i \cdot K_i}$$

für i = a, b, c und j = b, c, a.

Bei dieser Ausführungsform bilden diese normierten Oberkapazitätswerte Ca'(tn), Cb'(tn), Cc'(tn) die normierten Kennwerte.

Schritt 107: Für jede dieser Phasen A, B, C wird der normierte Kennwert mit dem jeweiligen Kennwert verglichen.

Bei dieser Ausführungsform werden Toleranzwerte CA > 0, CB > 0, CC > 0 für die Kennwertvergleiche bestimmt. Die Kapazitätsvergleiche erfolgen derart, dass zunächst geprüft wird, ob

$$\left|C_a'(t_n) - C_a\right| \le C_A \text{ und } \left|C_b'(t_n) - C_b\right| \le C_B \text{ und } \left|C_c'(t_n) - C_c\right| \le C_C$$

gilt. Falls ja, wird ein Schritt 108 ausgeführt. Falls nein, wird ein Schritt 109 ausgeführt.

Schritt 108: Ein Überwachungssignal wird erzeugt, das anzeigt, dass die Kondensatordurchführungen 2a, 2b, 2c in ordnungsgemäßem Zustand sind. Anschließend erfolgt Sprung zu Schritt 103.

Schritt 109: Die Kapazitätsvergleiche erfolgen außerdem derart, dass geprüft wird, ob

$$C_a'(t_n) - C_a < -C_A \text{ und } C_b'(t_n) - C_b > C_B \text{ und } \left|C_c'(t_n) - C_c\right| \le C_C$$

gilt. Falls ja, wird ein Schritt 110 ausgeführt. Falls nein, wird ein Schritt 111 ausgeführt.

Schritt 110: Ein Überwachungssignal wird erzeugt, das anzeigt, dass zumindest die zweite Kondensatordurchführung 2b nicht in ordnungsgemäßem Zustand ist. Anschließend erfolgt Sprung zu einem Schritt 122.

Schritt 111: Die Kapazitätsvergleiche erfolgen außerdem derart, dass geprüft wird, ob

$$C_b'(t_n) - C_b < -C_B \text{ und } C_c'(t_n) - C_c > C_C \text{ und } \left|C_a'(t_n) - C_a\right| \le C_A$$

gilt. Falls ja, wird ein Schritt 112 ausgeführt. Falls nein, wird ein Schritt 113 ausgeführt.

Schritt 112: Ein Überwachungssignal wird erzeugt, das anzeigt, dass zumindest die dritte Kondensatordurchführung 2c nicht in ordnungsgemäßem Zustand ist. Anschließend erfolgt Sprung zu Schritt 122.

Schritt 113: Die Kapazitätsvergleiche erfolgen außerdem derart, dass geprüft wird, ob

$$C'_c(t_n) - C_c < -C_C \text{ und } C'_a(t_n) - C_a > C_A \text{ und } \left| C'_b(t_n) - C_b \right| \leq C_B$$

gilt. Falls ja, wird ein Schritt 114 ausgeführt. Falls nein, wird ein Schritt 115 ausgeführt.

Schritt 114: Ein Überwachungssignal wird erzeugt, das anzeigt, dass zumindest die erste Kondensatordurchführung 2a nicht in ordnungsgemäßem Zustand ist. Anschließend erfolgt Sprung zu Schritt 122.

Schritt 115: Ein Überwachungssignal wird erzeugt, das anzeigt, dass zumindest zwei Kondensatordurchführungen nicht in ordnungsgemäßem Zustand sind.

Schritt 116: Die Kapazitätsvergleiche erfolgen außerdem derart, dass geprüft wird, ob

$$C'_a(t_n) - C_a > C_A \text{ und } C'_b(t_n) - C_b < -C_B \text{ und } \left| C'_c(t_n) - C_c \right| \leq C_C$$

gilt. Falls ja, wird ein Schritt 117 ausgeführt. Falls nein, wird ein Schritt 118 ausgeführt.

Schritt 117: Ein Überwachungssignal wird erzeugt, das anzeigt, dass die erste und die dritte Kondensatordurchführung 2a, 2c nicht in ordnungsgemäßem Zustand sind und einen gleichartigen Fehler haben. Anschließend erfolgt Sprung zu Schritt 122.

Schritt 118: Die Kapazitätsvergleiche erfolgen außerdem derart, dass geprüft wird, ob

$$C'_b(t_n) - C_b > C_B \text{ und } C'_c(t_n) - C_c < -C_C \text{ und } \left| C'_a(t_n) - C_a \right| \leq C_A$$

gilt. Falls ja, wird ein Schritt 119 ausgeführt. Falls nein, wird ein Schritt 120 ausgeführt.

Schritt 119: Ein Überwachungssignal wird erzeugt, das anzeigt, dass die zweite und die erste Kondensatordurchführung 2b, 2a nicht in ordnungsgemäßem Zustand sind und einen gleichartigen Fehler haben. Anschließend erfolgt Sprung zu Schritt 122.

Schritt 120: Die Kapazitätsvergleiche erfolgen außerdem derart, dass geprüft wird, ob

$$C'_c(t_n) - C_c > C_C \text{ und } C'_a(t_n) - C_a < -C_A \text{ und } \left| C'_b(t_n) - C_b \right| \leq C_B$$

gilt. Falls ja, wird ein Schritt 121 ausgeführt. Falls nein, wird ein Schritt 122 ausgeführt.

Schritt 121: Ein Überwachungssignal wird erzeugt, das anzeigt, dass die dritte und die zweite Kondensatordurchführung 2c, 2b nicht in ordnungsgemäßem Zustand sind und einen gleichartigen Fehler haben. Anschließend erfolgt Sprung zu Schritt 122.

Schritt 122: Ein Überwachungssignal wird erzeugt, das anzeigt, dass wenigstens zwei Kondensatordurchführungen nicht in ordnungsgemäßem Zustand sind und einen nicht gleichartigen Fehler haben. Anschließend wird das Verfahren beendet oder erfolgt nach Bedarf Sprung zu Schritt 103.

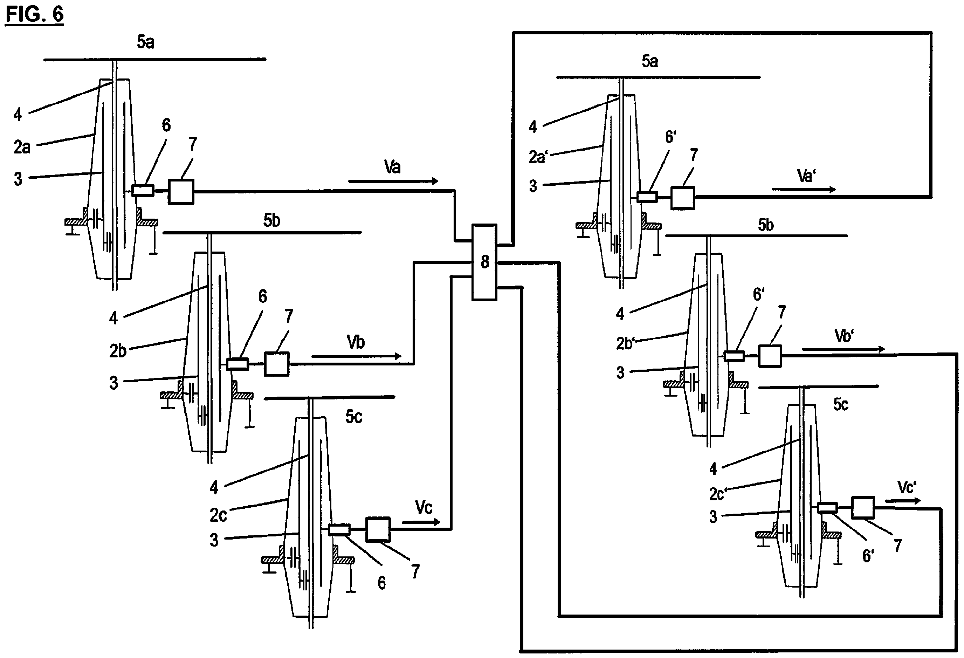

In FIG. 6 ist eine zweite Ausführungsform der Vorrichtung 1 schematisch dargestellt. Diese Ausführungsform ähnelt der ersten Ausführungsform, sodass im Folgenden vor Allem die Unterschiede näher erläutert werden.

Diese Ausführungsform ist beispielsweise für ein Wechselstromnetz geeignet, das zusätzlich zu dem ersten elektrischen Gerät, das über die drei Kondensatordurchführungen 2a, 2b, 2c an die drei Phasen A, B, C angeschlossen ist, ein zweites elektrisches Gerät (nicht dargestellt) umfasst, das parallel zu dem ersten Gerät an die drei Phasen angeschlossen ist und hier auch als Parallel-Gerät bezeichnet wird. Dieses Parallel-Gerät ist analog zu dem ersten Gerät über drei eigene Kondensatordurchführungen 2a', 2b', 2c', die hier auch als Parallel-Kondensatordurchführungen bezeichnet werden, an die drei Netzleitungen 5a, 5b, 5c angeschlossen.

Bei dieser Ausführungsform entfallen die Spannungswandler 9 und umfasst die Vorrichtung 1 stattdessen für jede der drei Phasen A, B, C einen Parallel-Messadapter 6', der mit dem Belag 3 der jeweiligen Parallel-Kondensatordurchführung 2a', 2b', 2c' verbunden ist, sowie eine Messeinrichtung 7, die an den jeweiligen Parallel-Messadapter 6' und die Auswerteeinrichtung 8 gekoppelt ist. Die Auswerteeinrichtung 8 bildet somit eine gemeinsame Auswerteeinrichtung 8 für alle sechs Messeinrichtungen 7.

Jede dieser Messeinrichtungen 7 ist derart ausgebildet, dass sie für die jeweilige Phase A, B, C eine Parallel-Belagspannung Va', Vb', Vc', die zwischen dem Belag 3 der jeweiligen Parallel-Kondensatordurchführung 2a', 2b', 2c' und Massepotenzial 13 anliegt, mithilfe des jeweiligen Parallel-Messadapters 6' erfassen kann. Die Auswerteeinrichtung 8 ist derart ausgebildet, dass sie für jede dieser Phasen zu dem anfänglichen oder einem späteren Zeitpunkt die Parallel-Belagspannung mithilfe der jeweiligen Messeinrichtung 7 erfassen und einen entsprechenden anfänglichen oder späteren Belagspannungswert, der den jeweiligen anfänglichen oder späteren Referenzspannungswert bildet, ermitteln kann.

Bei dieser Ausführungsform ist also jede Referenzspannung die jeweilige Parallel-Belagspannung. Da somit die Parallel-Belagspannungswerte die Referenzspannungswerte bilden, kann auf die Erfassung der Netzspannungen verzichtet werden.

Diese zweite Ausführungsform der Vorrichtung 1 der FIG. 6 kann beispielsweise eine zweite Ausführungsform des Verfahren ausführen. Diese Ausführungsform ähnelt der ersten Ausführungsform, sodass im Folgenden vor Allem die Unterschiede näher erläutert werden.

Bei dieser Ausführungsform wird in Schritt 202 für jede dieser Phasen A, B, C nicht die Netzspannung erfasst, sondern wird die Parallel-Belagspannung mithilfe des jeweiligen Parallel-Messadapters 6' und der Messeinrichtung 7 erfasst und ein entsprechender anfänglicher Parallel-Belagspannungswert Va'(t0), Vb'(t0), Vc'(t0) durch die Auswerteeinrichtung 8 ermittelt. Somit bilden diese Parallel-Belagspannungen die Referenzspannungen und diese anfänglichen Parallel-Belagspannungswert die anfänglichen Referenzspannungswerte Ra(t0), Rb(t0), Rc(t0).

Bei dieser Ausführungsform wird in Schritt 103 für jede dieser Phasen A, B, C nicht die Netzspannung erfasst, sondern wird die Parallel-Belagspannung mithilfe des jeweiligen Parallel-Messadapters 6' und der Messeinrichtung 7 erfasst und ein entsprechender Parallel-Belagspannungswert Va'(t), Vb'(t), Vc'(t) durch die Auswerteeinrichtung 8 ermittelt.

Bei dieser Ausführungsform werden in Schritt 104 die Netzspannungswerte Ua(t), Ub(t), Uc(t) durch diese Parallel-Belagspannungswerte Va'(t), Vb'(t), Vc'(t) ersetzt.

Bei dieser Ausführungsform wird in Schritt 106 für jede dieser Phasen A, B, C nicht die Netzspannung erfasst, sondern wird die Parallel-Belagspannung mithilfe des jeweiligen Parallel-Messadapters 6' und der Messeinrichtung 7 erfasst und ein entsprechender späterer Parallel-Belagspannungswert Va'(tn), Vb'(tn), Vc'(tn) durch die Auswerteeinrichtung 8 ermittelt. Somit bilden diese späteren Parallel-Belagspannungswert Va'(tn), Vb'(tn), Vc'(tn) die späteren Referenzspannungswerte Ra(tn), Rb(tn), Rc(tn).

**BEZUGSZEICHEN**

| | |
|---|---|
| 1 | Vorrichtung zum Überwachen von Kondensatordurchführungen |
| 2a/2b/2c | erste/zweite/dritte zu überwachende Kondensatordurchführung |
| 2a'/2b'/2c' | erste/zweite/dritte Parallel-Kondensatordurchführung |
| 3 | Belag von 2, 2' |
| 4 | Leiter von 2, 2' |
| 5a/5b/5c | erste/zweite/dritte Netzleitung |
| 6 | Messadapter |
| 6' | Parallel-Messadapter |
| 7 | Messeinrichtung |
| 7' | Überspannungsschutz |
| 8 | Auswerteeinrichtung |
| 9a/9b/9c | erster/zweiter/dritter Spannungswandler |
| 11 | Isolationskörper |
| 12 | Flansch |
| 13 | Massepotenzial |
| A/B/C | erste/zweite/dritte Phase |
| Ja/Jb/Jc | erster/zweiter/dritter Unterspannungskondensator |
| K1, K2 | Kondensatoren in 9 |
| Ka/Kb/Kc | erster/zweiter/dritter Oberspannungskondensator |
| La/Lb/Lc | erster/zweiter/dritter Außenkondensator |
| Ma/Mb/Mc | erster/zweiter/dritter Messkondensator |
| W1, W2 | Wicklungen in 9 |
| Ba/Bb/Bc | Unterkapazitätswert von Ja/Jb/Jc |
| Ca/Cb/Cc | Oberkapazitätswert von Ka/Kb/Kc, Kennwert für A/B/C |
| Ca'/Cb'/Cc' | normierter Oberkapazitätswert von Ka/Kb/Kc, normierter Kennwert für A/B/C |
| CA/CB/CC | Toleranzwert für A/B/C |

| Ka/Kb/Kc | Korrekturwert für A/B/C |
| Ra/Rb/Rc | erste/zweite/dritte Referenzspannung |
| Rae/Rbe/Rce | Effektivwert von Na/Nb/Nc |
| t0/t1 /tn | anfänglicher Zeitpunkt/intermediärer/späterer Zeitpunkt |
| Ua/Ub/Uc | erste/zweite/dritte Netzspannung |
| Uae/Ube/Uce | Effektivwert von Ua/Ub/Uc |
| UAB/UBC/UCA | Toleranzwert für A/B/C |
| Va/Vb/Vc | erste/zweite/dritte Belagspannung von 2 |
| Va'/Vb'/Vc' | erste/zweite/dritte Parallel-Belagspannung von 2' |

**Patentansprüche**

1. Verfahren zum Überwachen von Kondensatordurchführungen (2a, 2b, 2c) für ein Wechselstromnetz, wobei

- das Wechselstromnetz eine erste, zweite und dritte Phase (A, B, C) hat und umfasst:

  • eine erste Netzleitung (5a), der die erste Phase (A) und eine erste Kondensatordurchführung (2a) zugeordnet sind und an der eine erste Netzspannung anliegt,
  • eine zweite Netzleitung (5b), der die zweite Phase (B) und eine zweite Kondensatordurchführung (2b) zugeordnet sind und an der eine zweite Netzspannung anliegt,
  • eine dritte Netzleitung (5c), der die dritte Phase (C) und eine dritte Kondensatordurchführung (2c) zugeordnet sind und an der eine dritte Netzspannung anliegt;

- jede dieser Kondensatordurchführungen (2a, 2b, 2c) umfasst:

  • einen Leiter (4), der mit der zugeordneten Netzleitung (5a, 5b, 5c) verbunden ist,
  • einen elektrisch leitfähigen Belag (3), der diesen Leiter (4) umgibt;

- für jede dieser Phasen (A, B, C)

  • zu einem vorbestimmten anfänglichen Zeitpunkt (t0) für eine Kenngröße, die für die jeweilige Kondensatordurchführung (2a, 2b, 2c) charakteristisch ist, ein entsprechender Kennwert ermittelt wird; **gekennzeichnet dadurch, dass**
  • zu einem vorbestimmten späteren Zeitpunkt (tn) nach dem anfänglichen Zeitpunkt (t0) für die Kenngröße ein entsprechender normierter Kennwert in Abhängigkeit von dem jeweiligen und/oder von wenigstens einem der übrigen Kennwerte der verbleibenden Phasen ermittelt wird;
  • zu dem anfänglichen Zeitpunkt (t0) für eine Referenzspannung ein entsprechender anfänglicher Referenzspannungswert ermittelt wird;
  • das Ermitteln des normierten Kennwerts zusätzlich von dem jeweiligen anfänglichen Referenzspannungswert und/oder von wenigstens einem der übrigen anfänglichen Referenzspannungswerte der verbleibenden Phasen abhängt.
  • überprüft wird, ob der normierte Kennwert sich unzulässig geändert hat und;

- die Kenngröße die Oberkapazität eines jeweiligen Oberspannungskondensators und/oder der Verlustfaktor der jeweiligen Kondensatordurchführung ist, wobei der jeweilige Oberspannungskondensator durch den jeweiligen Belag und Leiter gebildet ist.

2. Verfahren nach Anspruch 1, wobei

- jede Referenzspannung von der jeweiligen Netzspannung abhängt.

3. Verfahren nach Anspruch 2, wobei

- jede Referenzspannung die jeweilige Netzspannung ist;
- für jede dieser Phasen (A, B, C)

  • zu dem anfänglichen Zeitpunkt (t0) die Netzspannung erfasst und ein entsprechender anfänglicher Netzspannungswert ermittelt wird;

• der anfängliche Netzspannungswert den jeweiligen anfänglichen Referenzspannungswert bildet.

4. Verfahren nach Anspruch 2, wobei

- der ersten Netzleitung (5a) eine erste Parallel-Kondensatordurchführung (2a') zugeordnet ist;
- der zweiten Netzleitung (5b) eine zweite Parallel-Kondensatordurchführung (2b') zugeordnet ist;
- der dritten Netzleitung (5c) eine dritte Parallel-Kondensatordurchführung (2c') zugeordnet ist;
- jede dieser Parallel-Kondensatordurchführungen (2a', 2b', 2c') umfasst:

• einen Leiter (4), der mit der zugeordneten Netzleitung (5a, 5b, 5c) verbunden ist,
• einen elektrisch leitfähigen Belag (3), der diesen Leiter (4) umgibt;

- jede Referenzspannung eine Parallel-Belagspannung, die zwischen dem Belag (3) und Massepotenzial (13) der jeweiligen Parallel-Kondensatordurchführung anliegt, ist;
- für jede dieser Phasen (A, B, C)

• zu dem anfänglichen Zeitpunkt (t0) die Parallel-Belagspannung erfasst und ein entsprechender anfänglicher Parallel-Belagspannungswert ermittelt wird;
• der anfängliche Parallel-Belagspannungswert den jeweiligen anfänglichen Referenzspannungswert bildet.

5. Verfahren nach Anspruch 1 oder einem der vorigen Ansprüche, wobei

- für jede dieser Phasen (A, B, C)

• die Referenzspannung eine Konstantspannung ist, für die ein entsprechender Konstantspannungswert vorbestimmt wird.

6. Verfahren nach Anspruch 1 oder einem der vorigen Ansprüche, wobei

- für jede dieser Phasen (A, B, C)

• zu dem anfänglichen Zeitpunkt (t0) eine Belagspannung, die zwischen dem jeweiligen Belag (3) und Massepotenzial (13) anliegt, erfasst und ein entsprechender anfänglicher Belagspannungswert ermittelt wird;
• das Ermitteln des normierten Kennwerts zusätzlich von dem jeweiligen anfänglichen Belagspannungswert und/oder von wenigstens einem der übrigen anfänglichen Belagspannungswerte abhängt.

7. Verfahren nach Anspruch 1 oder einem der vorigen Ansprüche, wobei

- eine Messeinrichtung (7) an diese Beläge (3) gekoppelt ist und für jede dieser Phasen (A, B, C) eine Belagspannung erfassen kann, die zwischen dem jeweiligen Belag (3) und Massepotenzial (13) anliegt;
- für jede dieser Phasen (A, B, C)

• ein Außenkondensator (La, Lb, Lc) von dem jeweiligen Belag (3) und Massepotenzial (13) gebildet ist;
• ein Unterspannungskondensator (Ja, Jb, Jc) durch eine Parallelschaltung gebildet ist, die die Messeinrichtung (7) und den Außenkondensator umfasst;
• zu oder dem anfänglichen Zeitpunkt (t0) für die Unterkapazität des Unterspannungskondensators ein entsprechender Unterkapazitätswert ermittelt wird;
• das Ermitteln des normierten Kennwerts zusätzlich von dem jeweiligen Unterkapazitätswert und/oder von wenigstens einem der übrigen Unterkapazitätswerte abhängt.

8. Verfahren nach Anspruch 7, wobei

- für jede dieser Phasen (A, B, C)

• ein Oberspannungskondensator (Ka, Kb, Kc) durch den jeweiligen Belag (3) und Leiter (4) gebildet ist;
• die jeweilige Kenngröße die Oberkapazität des jeweiligen Oberspannungskondensators und der jeweilige Kennwert ein entsprechender Oberkapazitätswert ist;

- zu dem späteren Zeitpunkt (tn) für jede dieser Phasen (A, B, C)

• die Belagspannung erfasst und ein entsprechender späterer Belagspannungswert ermittelt wird;

- der normierte Oberkapazitätswert der ersten Kondensatordurchführung (2a) gemäß folgender Formel berechnet wird:

$$C'_a(t_n) = B_a \cdot \frac{V_a(t_n) \cdot N_a \cdot K_a}{V_b(t_n) \cdot N_b \cdot \left(\frac{B_b}{C_b}+1\right) - V_a(t_n) \cdot N_a \cdot K_a}$$

mit

$$N_a = \frac{R_a(t_0)}{V_a(t_0)} \cdot \frac{C_a}{B_a + C_a}$$

worin Ka ein vorbestimmter konstanter oder variabler erster Korrekturwert ist; und/oder
- der normierte Oberkapazitätswert der zweiten Kondensatordurchführung (2b) gemäß folgender Formel berechnet wird:

$$C'_b(t_n) = B_b \cdot \frac{V_b(t_n) \cdot N_b \cdot K_b}{V_c(t_n) \cdot N_c \cdot \left(\frac{B_c}{C_c}+1\right) - V_b(t_n) \cdot N_b \cdot K_a}$$

mit

$$N_b = \frac{R_b(t_0)}{V_b(t_0)} \cdot \frac{C_b}{B_b + C_b}$$

worin Kb ein vorbestimmter konstanter oder variabler zweiter Korrekturwert ist; und/oder
- der normierte Oberkapazitätswert der dritten Kondensatordurchführung (2c) gemäß folgender Formel berechnet wird:

$$C'_c(t_n) = B_c \cdot \frac{V_c(t_n) \cdot N_c \cdot K_c}{V_a(t_n) \cdot N_a \cdot \left(\frac{B_a}{C_a}+1\right) - V_c(t_n) \cdot N_c \cdot K_c}$$

mit

$$N_c = \frac{R_c(t_0)}{V_c(t_0)} \cdot \frac{C_c}{B_c + C_c}$$

worin Kc ein vorbestimmter konstanter oder variabler dritter Korrekturwert ist;
- Ba, Bb und Bc der erste, zweite und dritte Unterkapazitätswert sind;

- Ca, Cb und Cc der erste, zweite und dritte Oberkapazitätswert sind;
- Ra(t0), Rb(t0) und Rc(t0) der erste, zweite und dritte anfängliche Referenzspannungswert sind;
- Va(tn), Vb(tn) und Vc(tn ) der erste, zweite und dritte spätere Belagspannungswert sind.

9. Verfahren nach dem vorigen Anspruch, wobei

- Ka = 1 gilt; oder
- Ka = Rb(tn)/Ra(tn) gilt, worin

    • Ra(tn) ein späterer erster Referenzspannungswert ist, der zu dem späteren Zeitpunkt (tn) für eine erste Referenzspannung, die der ersten Phase (A) zugeordnet ist, ermittelt wird;
    • Rb(tn) ein späterer zweiter Referenzspannungswert ist, der zu diesem späteren Zeitpunkt (tn) für eine zweite Referenzspannung, die der zweiten, der ersten Phase (A) benachbarten Phase (B) zugeordnet ist, ermittelt wird;
    und/oder wobei

- Kb = 1 gilt; oder
- Kb = Rc(tn)/Rb(tn) gilt, worin

    • Rb(tn) ein späterer zweiter Referenzspannungswert ist, der zu dem späteren Zeitpunkt (tn) für eine zweite Referenzspannung, die der zweiten Phase (A) zugeordnet ist, ermittelt wird;
    • Rc(tn) ein späterer dritter Referenzspannungswert ist, der zu diesem späteren Zeitpunkt (tn) für eine dritte Referenzspannung, die der dritten, der zweiten Phase (B) benachbarten Phase (C) zugeordnet ist, ermittelt wird;
    und/oder wobei

- Kc = 1 gilt; oder
- Kc = Ra(tn)/Rc(tn) gilt, worin

    • Rc(tn) ein späterer dritter Referenzspannungswert ist, der zu dem späteren Zeitpunkt (tn) für eine dritte Referenzspannung, die der dritten Phase (B) zugeordnet ist, ermittelt wird;
    • Ra(tn) ein späterer erster Referenzspannungswert ist, der zu diesem späteren Zeitpunkt (tn) für eine erste Referenzspannung, die der ersten, der dritten Phase (C) benachbarten Phase (A) zugeordnet ist, ermittelt wird.

10. Verfahren nach Anspruch 1 oder einem der vorigen Ansprüche, wobei

- beim Überprüfen der jeweilige normierte Kennwert mit dem jeweiligen Kennwert verglichen wird.

11. Verfahren nach dem vorigen Anspruch, wobei

- Toleranzwerte CA > 0, CB > 0, CC > 0 für die Kennwertvergleiche bestimmt werden;
- falls die Kennwertvergleiche ergeben, dass

$$\left| C'_a(t_n) - C_a \right| \leq C_A \text{ und } \left| C'_b(t_n) - C_b \right| \leq C_B \text{ und } \left| C'_c(t_n) - C_c \right| \leq C_C$$

gilt, dann ein Überwachungssignal erzeugt wird, das anzeigt, dass die Kondensatordurchführungen (2a, 2b, 2c) in ordnungsgemäßem Zustand sind.

12. Verfahren nach Anspruch 10 oder 11, wobei

- Toleranzwerte CA > 0, CB > 0, CC > 0 für die Kennwertvergleiche bestimmt werden;
- falls die Kennwertvergleiche ergeben, dass

$$C'_a(t_n) - C_a < -C_A \text{ und } C'_b(t_n) - C_b > C_B \text{ und } \left| C'_c(t_n) - C_c \right| \leq C_C$$

gilt, dann ein Überwachungssignal erzeugt wird, das anzeigt, dass zumindest die zweite Kondensatordurchführung (2b) nicht in ordnungsgemäßem Zustand ist;
- falls die Kennwertvergleiche ergeben, dass

$$C_b'(t_n) - C_b < -C_B \text{ und } C_c'(t_n) - C_c > C_C \text{ und } \left|C_a'(t_n) - C_a\right| \leq C_A$$

gilt, dann ein Überwachungssignal erzeugt wird, das anzeigt, dass zumindest die dritte Kondensatordurchführung (2c) nicht in ordnungsgemäßem Zustand ist;
- falls die Kennwertvergleiche ergeben, dass

$$C_c'(t_n) - C_c < -C_C \text{ und } C_a'(t_n) - C_a > C_A \text{ und } \left|C_b'(t_n) - C_b\right| \leq C_B$$

gilt, dann ein Überwachungssignal erzeugt wird, das anzeigt, dass zumindest die erste Kondensatordurchführung (2a) nicht in ordnungsgemäßem Zustand ist;
- andernfalls ein Überwachungssignal erzeugt wird, das anzeigt, dass zumindest zwei dieser Kondensatordurchführungen nicht in ordnungsgemäßem Zustand sind.

**13.** Verfahren nach Anspruch 10 bis 12, wobei

- Toleranzwerte CA > 0, CB > 0, CC > 0 für die Kennwertvergleiche bestimmt werden;
- falls die Kennwertvergleiche ergeben, dass

$$C_a'(t_n) - C_a > C_A \text{ und } C_b'(t_n) - C_b < -C_B \text{ und } \left|C_c'(t_n) - C_c\right| \leq C_C$$

gilt, dann ein Überwachungssignal erzeugt wird, das anzeigt, dass die erste und die dritte Kondensatordurchführung (2a, 2c) nicht in ordnungsgemäßem Zustand sind und einen gleichartigen Fehler haben;
- falls die Kennwertvergleiche ergeben, dass

$$C_b'(t_n) - C_b > C_B \text{ und } C_c'(t_n) - C_c < -C_C \text{ und } \left|C_a'(t_n) - C_a\right| \leq C_A$$

gilt, dann ein Überwachungssignal erzeugt wird, das anzeigt, dass die zweite und die erste Kondensatordurchführung (2b, 2a) nicht in ordnungsgemäßem Zustand sind und einen gleichartigen Fehler haben;
- falls die Kennwertvergleiche ergeben, dass

$$C_c'(t_n) - C_c > C_C \text{ und } C_a'(t_n) - C_a < -C_A \text{ und } \left|C_b'(t_n) - C_b\right| \leq C_B$$

gilt, dann ein Überwachungssignal erzeugt wird, das anzeigt, dass die dritte und die zweite Kondensatordurchführung (2c, 2b) nicht in ordnungsgemäßem Zustand sind und einen gleichartigen Fehler haben.

**14.** Verfahren nach Anspruch 1 oder einem der vorigen Ansprüche, wobei

- zu einem intermediären Zeitpunkt (t1) vor dem Ermitteln des normierten Kennwerts

  • für jede dieser Phasen (A, B, C) die Referenzspannung erfasst und ein entsprechender intermediärer Referenzspannungswert ermittelt wird;
  • diese intermediären Referenzspannungswerte untereinander verglichen werden;
  • das Ermitteln der normierten Kennwerte erfolgt, falls diese Vergleiche ergeben, dass diese intermediären Referenzspannungswerte nicht mehr als ein vorbestimmtes Maß voneinander abweichen.

**15.** Verfahren nach dem vorigen Anspruch, wobei

- diese Spannungsvergleiche derart erfolgen, dass

- Toleranzwerte RAB > 0, RBC > 0, RCA > 0 als das jeweilige Maß bestimmt werden;
- geprüft wird, ob

$$\left|R_a(t_1) - R_b(t_1)\right| \le R_{AB}$$

und

$$\left|R_b(t_1) - R_c(t_1)\right| \le R_{BC}$$

und

$$\left|R_c(t_1) - R_a(t_1)\right| \le R_{CA}$$

gilt;

- Ra(t1) der intermediäre Referenzspannungswert der ersten Phase ist;
- Rb(t1) der intermediäre Referenzspannungswert der zweiten Phase ist;
- Rc(t1) der intermediäre Referenzspannungswert der dritten Phase ist.

**16.** Vorrichtung (1) zum Überwachen von Kondensatordurchführungen (2a, 2b, 2c) für ein Wechselstromnetz, wobei

- das Wechselstromnetz eine erste, zweite und dritte Phase (A, B, C) hat und umfasst:

  - eine erste Netzleitung (5a), der die erste Phase (A) und eine erste Kondensatordurchführung (2a) zugeordnet sind und an der eine erste Netzspannung anliegt,
  - eine zweite Netzleitung (5b), der die zweite Phase (B) und eine zweite Kondensatordurchführung (2b) zugeordnet sind und an der eine zweite Netzspannung anliegt,
  - eine dritte Netzleitung (5c), der die dritte Phase (C) und eine dritte Kondensatordurchführung (2c) zugeordnet sind und an der eine dritte Netzspannung anliegt;

- jede dieser Kondensatordurchführungen (2a, 2b, 2c) umfasst:

  - einen Leiter (4), der mit der zugeordneten Netzleitung (5a, 5b, 5c) verbunden ist;
  - einen elektrisch leitfähigen Belag (3), der diesen Leiter (4) umgibt;

- die Vorrichtung (1) umfasst:

  - eine Auswerteeinrichtung (8), die an die Kondensatordurchführungen (2a, 2b, 2c) gekoppelt ist;

- die Auswerteeinrichtung (8) derart ausgebildet ist, dass sie für jede dieser Phasen (A, B, C)

  - zu einem vorbestimmten anfänglichen Zeitpunkt (t0) für eine Kenngröße, die für die jeweilige Kondensatordurchführung (2a, 2b, 2c) charakteristisch ist, einen entsprechenden Kennwert ermitteln kann; **gekennzeichnet dadurch, dass** die Auswerteeinrichtung (8)
  - zu einem oder dem vorbestimmten späteren Zeitpunkt (tn) nach dem anfänglichen Zeitpunkt (t0) für die Kenngröße einen entsprechenden normierten Kennwert in Abhängigkeit von dem jeweiligen Kennwert und/oder von wenigstens einem der übrigen Kennwerte der verbleibenden Phasen ermitteln kann;
  - zu dem anfänglichen Zeitpunkt (t0) für eine Referenzspannung einen entsprechenden anfänglichen Referenzspannungswert ermitteln kann;
  - das Ermitteln des normierten Kennwerts zusätzlich von dem jeweiligen anfänglichen Referenzspannungswert und/oder von wenigstens einem der übrigen anfänglichen Referenzspannungswerte abhängt
  - überprüfen kann, ob der normierte Kennwert sich unzulässig geändert hat und

- die Kenngröße die Oberkapazität eines jeweiligen Oberspannungskondensators und/oder der Verlustfaktor der jeweiligen Kondensatordurchführung ist, wobei der jeweilige Oberspannungskondensator durch den jeweiligen Belag und Leiter gebildet ist.

17. Vorrichtung (1) nach Anspruch 16, umfassend

- einen ersten Spannungswandler (9a), der mit der ersten Netzleitung (5a) verbunden werden kann;
- einen zweiten Spannungswandler (9b), der mit der zweiten Netzleitung (5b) verbunden werden kann;
- einen dritten Spannungswandler (9c), der mit der dritten Netzleitung (5c) verbunden werden kann;
- eine Auswerteeinrichtung (8), die an die Spannungswandler (9a, 9b, 9c) und die Messeinrichtung (7) gekoppelt ist;

wobei

- jeder dieser Spannungswandler (9a, 9b, 9c) für die jeweilige Phase (A, B, C) die Netzspannung erfassen kann;
- jede Referenzspannung die jeweilige Netzspannung ist;
- die Auswerteeinrichtung (8) derart ausgebildet ist, dass sie für jede dieser Phasen (A, B, C)

  • zu dem anfänglichen Zeitpunkt (t0) die Netzspannung mithilfe des jeweiligen Spannungswandlers (9a, 9b, 9c) erfassen und einen entsprechenden anfänglichen Netzspannungswert ermitteln kann;

- für jede dieser Phasen (A, B, C)

  • der anfängliche Netzspannungswert den jeweiligen anfänglichen Referenzspannungswert bildet.

18. Vorrichtung (1) nach Anspruch 16, wobei

- der ersten Netzleitung (5a) eine erste Parallel-Kondensatordurchführung (2a') zugeordnet ist;
- der zweiten Netzleitung (5b) eine zweite Parallel-Kondensatordurchführung (2b') zugeordnet ist;
- der dritten Netzleitung (5c) eine dritte Parallel-Kondensatordurchführung (2c') zugeordnet ist;
- jede dieser Parallel-Kondensatordurchführungen (2a', 2b', 2c') umfasst:

  • einen Leiter (4), der mit der zugeordneten Netzleitung (5a, 5b, 5c) verbunden ist,
  • einen elektrisch leitfähigen Belag (3), der diesen Leiter (4) umgibt;

- die Vorrichtung (1) umfasst:

  • einen ersten Parallel-Messadapter (6'), der mit dem Belag (3) der ersten Parallel-Kondensatordurchführung (2a') verbunden werden kann;
  • einen zweiten Parallel-Messadapter (6'), der mit dem Belag (3) der zweiten Parallel-Kondensatordurchführung (2b') verbunden werden kann;
  • einen dritten Parallel-Messadapter (6'), der mit dem Belag (3) der dritten Parallel-Kondensatordurchführung (2c') verbunden werden kann;
  • eine Messeinrichtung (7), die an die Parallel-Messadapter (6') gekoppelt ist;

- die Messeinrichtung (7) für jede dieser Phasen (A, B, C) eine Parallel-Belagspannung, die zwischen dem jeweiligen Belag (3) und Massepotenzial (13) anliegt, mithilfe des jeweiligen Parallel-Messadapters (6') erfassen kann;
- jede Referenzspannung die jeweilige Parallel-Belagspannung ist;
- die Auswerteeinrichtung (8) derart ausgebildet ist, dass sie für jede dieser Phasen (A, B, C)

  • zu dem anfänglichen Zeitpunkt (t0) die Parallel-Belagspannung mithilfe der Messeinrichtung (7) erfassen und einen entsprechenden anfänglichen Belagspannungswert ermitteln kann;

- für jede dieser Phasen (A, B, C)

  • der anfängliche Parallel-Belagspannungswert den jeweiligen anfänglichen Referenzspannungswert bildet.

19. Vorrichtung (1) nach Anspruch 16 oder einem der 2 vorigen Ansprüche, umfassend

- einen ersten Messadapter (6), der mit dem Belag (3) der ersten Kondensatordurchführung (2a) verbunden werden kann;
- einen zweiten Messadapter (6), der mit dem Belag (3) der zweiten Kondensatordurchführung (2b) verbunden werden kann;
- einen dritten Messadapter (6), der mit dem Belag (3) der dritten Kondensatordurchführung (2c) verbunden werden kann;
- eine oder die Messeinrichtung (7), die an die Messadapter (6) gekoppelt ist;

wobei

- die Auswerteeinrichtung (8) an die Messeinrichtung (7) gekoppelt ist;
- die Messeinrichtung (7) für jede dieser Phasen (A, B, C) eine Belagspannung, die zwischen dem jeweiligen Belag (3) und Massepotenzial (13) anliegt, mithilfe des jeweiligen Messadapters (6) erfassen kann;
- die Auswerteeinrichtung (8) derart ausgebildet ist, dass sie für jede dieser Phasen (A, B, C)

• zu dem anfänglichen Zeitpunkt (t0) die Belagspannung mithilfe der Messeinrichtung (7) erfassen und einen entsprechenden anfänglichen Belagspannungswert ermitteln kann;

- für jede dieser Phasen (A, B, C)

• das Ermitteln des normierten Kennwerts zusätzlich von dem jeweiligen anfänglichen Belagspannungswert und/oder von wenigstens einem der übrigen anfänglichen Belagspannungswerte abhängt.

20. Vorrichtung (1) nach Anspruch 16 oder einem der 3 vorigen Ansprüche, wobei

- für jede dieser Phasen (A, B, C)

• ein Außenkondensator (La, Lb, Lc) von dem jeweiligen Belag (3) und Massepotenzial (13) gebildet ist;
• ein Unterspannungskondensator (Ja, Jb, Jc) durch eine Parallelschaltung gebildet ist, die die Messeinrichtung (7) und den jeweiligen Außenkondensator (La, Lb, Lc) umfasst;

- die Auswerteeinrichtung (8) derart ausgebildet ist, dass sie für jede dieser Phasen (A, B, C)

• zu dem anfänglichen Zeitpunkt (t0) für die Unterkapazität des Unterspannungskondensators einen entsprechenden Unterkapazitätswert ermitteln kann;

- für jede dieser Phasen (A, B, C)

• das Ermitteln des normierten Kennwerts zusätzlich von dem jeweiligen Unterkapazitätswert und/oder von wenigstens einem der übrigen Unterkapazitätswerte abhängt.

21. Vorrichtung (1) nach Anspruch 19, wobei

- für jede dieser Phasen (A, B, C)

• ein Oberspannungskondensator (Ka, Kb, Kc) durch den jeweiligen Belag (3) und Leiter (4) gebildet ist;
• die jeweilige Kenngröße die Oberkapazität des jeweiligen Oberspannungskondensators und der jeweilige Kennwert ein entsprechender Oberkapazitätswert ist;

- die Auswerteeinrichtung (8) derart ausgebildet ist, dass sie zu dem späteren Zeitpunkt (tn) für jede dieser Phasen (A, B, C)

• die Belagspannung erfassen und einen entsprechenden späteren Belagspannungswert ermitteln kann;

- die Auswerteeinrichtung (8) derart ausgebildet ist, dass sie den normierten Oberkapazitätswert der ersten Kondensatordurchführung (2a) gemäß folgender Formel berechnet:

$$C'_a(t_n) = B_a \cdot \frac{V_a(t_n) \cdot N_a \cdot K_a}{V_b(t_n) \cdot N_b \cdot \left(\frac{B_b}{C_b} + 1\right) - V_a(t_n) \cdot N_a \cdot K_a}$$

mit

$$N_a = \frac{R_a(t_0)}{V_a(t_0)} \cdot \frac{C_a}{B_a + C_a}$$

worin Ka ein vorbestimmter konstanter oder variabler erster Korrekturwert ist; und/oder
- die Auswerteeinrichtung (8) derart ausgebildet ist, dass sie den normierten Oberkapazitätswert der zweiten Kondensatordurchführung (2b) gemäß folgender Formel berechnet:

$$C'_b(t_n) = B_b \cdot \frac{V_b(t_n) \cdot N_b \cdot K_b}{V_c(t_n) \cdot N_c \cdot \left(\frac{B_c}{C_c} + 1\right) - V_b(t_n) \cdot N_b \cdot K_a}$$

mit

$$N_b = \frac{R_b(t_0)}{V_b(t_0)} \cdot \frac{C_b}{B_b + C_b}$$

worin Kb ein vorbestimmter konstanter oder variabler zweiter Korrekturwert ist; und/oder
- die Auswerteeinrichtung (8) derart ausgebildet ist, dass sie den normierten Oberkapazitätswert der dritten Kondensatordurchführung (2c) gemäß folgender Formel berechnet:

$$C'_c(t_n) = B_c \cdot \frac{V_c(t_n) \cdot N_c \cdot K_c}{V_a(t_n) \cdot N_a \cdot \left(\frac{B_a}{C_a} + 1\right) - V_c(t_n) \cdot N_c \cdot K_c}$$

mit

$$N_c = \frac{R_c(t_0)}{V_c(t_0)} \cdot \frac{C_c}{B_c + C_c}$$

worin Kc ein vorbestimmter konstanter oder variabler dritter Korrekturwert ist;
- Ba, Bb und Bc der erste, zweite und dritte Unterkapazitätswert sind;
- Ca, Cb und Cc der erste, zweite und dritte Oberkapazitätswert sind;
- Ra(t0), Rb(t0) und Rc(t0) der erste, zweite und dritte anfängliche Referenzspannungswert sind;
- Va(tn), Vb(tn) und Vc(tn ) der erste, zweite und dritte spätere Belagspannungswert sind.

22. Vorrichtung (1) nach Anspruch 18 oder 19 vorigen Ansprüche, wobei

- die Messeinrichtung (7) umfasst:

• einen ersten Messkondensator, der an den ersten Messadapter (6) angeschlossen ist;

• einen zweiten Messkondensator, der an den zweiten Messadapter (6) angeschlossen ist;
• einen dritten Messkondensator, der an den dritten Messadapter (6) angeschlossen ist;

- die Kapazitäten dieser drei Messkondensatoren ungleich sein;
- die drei Kapazitäten im Verhältnis 1:2:3 oder 1:2:4 oder 1:2:5 oder 1:3:5 oder 1:3:7 oder 1:3:9 oder 1:4:7 oder 1:4:9 zueinander stehen.

**Claims**

1. Method of monitoring capacitor bushings (2a, 2b, 2c) for an alternating current mains, wherein

    - the alternating current mains has a first, second and third phase (A, B, C) and comprises:

        • a first mains line (5a), with which the first phase (A) and a first capacitor bushing (2a) are associated and at which a first mains voltage is present,
        • a second mains line (5b), with which the second phase (B) and a second capacitor bushing (2b) are associated and at which a second mains voltage is present,
        • a third mains line (5c) with which the third phase (C) and a third capacitor bushing (2c) are associated and at which a third mains voltage is present;

    - each of these capacitor bushings (2a, 2b, 2c) comprises:

        • a conductor (4) connected with the associated mains line (5a, 5b, 5c),
        • an electrically conductive foil (3) enclosing this conductor (4);

    - for each of these phases (A, B, C)

        • at a predetermined initial instant (t0) for a characteristic variable, which is characteristic for the respective capacitor bushing (2a, 2b, 2c), a corresponding characteristic value is determined **characterized in that**;
        • at a predetermined later instant (tn) after the initial instant (t0) for the characteristic variable a corresponding normalised characteristic value is determined in dependence on the respective characteristic value and/or on at least one of the remaining characteristic values of the remaining phases;
        • at the initial instant (t0), a corresponding initial reference voltage value is determined for a reference voltage;
        • the determination of the normalised characteristic variable is additionally dependent on the respective initial reference voltage value and/or of at least one of the remaining initial reference voltage values of the remaining phases.
        • it is checked whether the normalised characteristic value has impermissibly changed and;

    - the characteristic variable is the upper capacitance of a respective upper-voltage capacitor and/or the loss factor of the respective capacitor bushing, wherein the respective upper-voltage capacitor is formed by the respective foil and conductor.

2. Method according to claim 1, wherein

    - each reference voltage depends on the respective mains voltage.

3. Method according to claim 2, wherein

    - each reference voltage is the respective mains voltage;
    - for each of these phases (A, B, C)

        • at the initial instant (t0) the mains voltage is detected and a corresponding initial mains voltage value is determined;
        • the initial mains voltage value forms the respective initial reference voltage value.

4. Method according to claim 2, wherein

- a first parallel capacitor bushing (2a') is associated with the first mains line (5a);
- a second parallel capacitor bushing (2b') is associated with the second mains line (5b);
- a third parallel capacitor bushing (2c') is associated with the third mains line (5c);
- each of these parallel capacitor bushings (2a', 2b', 2c') comprises:

  • a conductor (4) connected with the associated mains line (5a, 5b, 5c),
  • an electrically conductive foil (3) enclosing this conductor (4);

- each reference voltage is a parallel foil voltage present between the foil (3) and ground potential (13) of the respective parallel capacitor bushing;
- for each of these phases (A, B, C)

  • at the initial instant (t0) the parallel foil voltage is detected and a corresponding initial parallel foil voltage value is determined;
  • the initial parallel foil voltage value forms the respective initial reference voltage value.

5. Method according to claim 1 or any one of the other preceding claims, wherein

   - for each of these phases (A, B, C)

   • the reference voltage is a constant voltage for which a corresponding constant voltage value is predetermined.

6. Method according to claim 1 or any one of the other preceding claims, wherein

   - for each of these phases (A, B, C)

   • at the initial instant (t0) a foil voltage present between the respective foil (3) and ground potential (13) is detected and a corresponding initial foil voltage value is determined;
   • determination of the normalised characteristic value additionally depends on the respective initial foil voltage value and/or on at least one of the remaining initial foil voltage values.

7. Method according to claim 1 or any one of the other preceding claims, wherein

   - a measuring device (7) is coupled to these foils (3) and for each of these phases (A, B, C) a foil voltage present between the respective foil (3) and ground potential (13) can be detected;
   - for each of these phases (A, B, C)

   • an outer capacitor (La, Lb, Lc) is formed by the respective foil (3) and ground potential (13);
   • a lower-voltage capacitor (Ja, Jb, Jc) is formed by a parallel circuit, which comprises the measuring device (7) and the outer capacitor;
   • at the initial instant (t0) for the lower capacitance of the lower-voltage capacitor a corresponding lower capacitance value is determined;
   • determination of the normalised characteristic value additionally depends on the respective lower capacitance value and/or on at least one of the remaining lower capacitance values.

8. Method according to claim 1, wherein

   - for each of these phases (A, B, C)

   • an upper-voltage capacitor (Ka, Kb, Kc) is formed by the respective foil (3) and conductor (4);
   • the respective characteristic variable is the upper capacitance of the respective upper-voltage capacitor and the respective characteristic value is a corresponding upper capacitance value;

   - at the later instant (tn) for each of these phases (A, B, C)

   • the foil voltage is detected and a corresponding later foil voltage value is determined;

- the normalised upper capacitance value of the first capacitor bushing (2a) is calculated in accordance with the following equation:

$$C'_a(t_n) = B_a \cdot \frac{V_a(t_n) \cdot N_a \cdot K_a}{V_b(t_n) \cdot N_b \cdot \left(\dfrac{B_b}{C_b}+1\right) - V_a(t_n) \cdot N_a \cdot K_a}$$

wherein

$$N_a = \frac{R_a(t_0)}{V_a(t_0)} \cdot \frac{C_a}{B_a + C_a}$$

wherein Ka is a predetermined constant or variable first correction value;
and/or
- the normalised upper capacitance value of the second capacitor bushing (2b) is calculated in accordance with the following equation:

$$C'_b(t_n) = B_b \cdot \frac{V_b(t_n) \cdot N_b \cdot K_b}{V_c(t_n) \cdot N_c \cdot \left(\dfrac{B_c}{C_c}+1\right) - V_b(t_n) \cdot N_b \cdot K_a}$$

wherein

$$N_b = \frac{R_b(t_0)}{V_b(t_0)} \cdot \frac{C_b}{B_b + C_b}$$

wherein Kb is a predetermined constant or variable second correction value;
and/or
- the normalised upper capacitance value of the third capacitor bushing (2c) is calculated in accordance with the following equation:

$$C'_c(t_n) = B_c \cdot \frac{V_c(t_n) \cdot N_c \cdot K_c}{V_a(t_n) \cdot N_a \cdot \left(\dfrac{B_a}{C_a}+1\right) - V_c(t_n) \cdot N_c \cdot K_c}$$

wherein

$$N_c = \frac{R_c(t_0)}{V_c(t_0)} \cdot \frac{C_c}{B_c + C_c}$$

wherein Kc is a predetermined constant or variable third correction value;
- Ba, Bb and Bc are the first, second and third lower capacitance values;
- Ca, Cb and Cc are the first, second and third upper capacitance values;
- Ra(t0), Rb(t0) and Rc(t0) are the first, second and third initial reference voltage values;
- Va(tn), Vb(tn) and Vc(tn) are the first, second and third later foil voltage values.

9. Method according to the preceding claim, wherein

- Ka = 1; or
- Ka = Rb(tn)/Ra(tn), wherein

  • Ra(tn) is a later first reference voltage value determined at the later instant (tn) for a first reference voltage associated with the first phase (A);
  • Rb(tn) is a later second reference voltage value determined at this later instant (tn) for a second reference voltage associated with the second phase (B) adjacent to the first phase (A); and/or wherein

- Kb = 1; or
- Kb = Rc(tn)/Rb(tn), wherein

  • Rb(tn) is a later second reference voltage value determined at the later instant (tn) for a second reference voltage associated with the second phase (A);
  • Rc(tn) is a later third reference voltage value determined at this later instant (tn) for a third reference voltage associated with the third phase (C) adjacent to the second phase (B); and/or wherein

- Kc = 1; or
- Kc = Ra(tn)/Rc(tn), wherein

  • Rc(tn) is a later third reference voltage value determined at the later instant (tn) for a third reference voltage associated with the third phase (B);
  • Ra(tn) is a later first reference voltage value determined at this later instant (tn) for a first reference voltage associated with the first phase (A) adjacent to the third phase (C).

10. Method according to claim 1 or any one of the other preceding claims, wherein

- for the checking, the respective normalised characteristic value is compared with the respective characteristic value.

11. Method according to the preceding claim, wherein

- tolerance values CA > 0, CB > 0, CC > 0 for the characteristic value comparisons are determined;
- if the characteristic value comparisons have the result that

$$\left| C'_a(t_n) - C_a \right| \leq C_A \text{ and } \left| C'_b(t_n) - C_b \right| \leq C_B \text{ and } \left| C'_c(t_n) - C_c \right| \leq C_C$$

a monitoring signal indicating that the capacitor bushings (2a, 2b, 2c) are in proper state is generated.

12. Method according to claim 10 or11 , wherein

- tolerance values CA > 0, CB > 0, CC > 0 for the characteristic value comparisons are determined;
- if the characteristic value comparisons have the result that

$$C'_a(t_n) - C_a < -C_A \text{ and } C'_b(t_n) - C_b > C_B \text{ and } \left| C'_c(t_n) - C_c \right| \leq C_C$$

a monitoring signal indicating that at least the second capacitor bushing (2b) is not in proper state is generated;
- if the characteristic value comparisons have the result that

$$C'_b(t_n) - C_b < -C_B \text{ and } C'_c(t_n) - C_c > C_C \text{ and } \left| C'_a(t_n) - C_a \right| \leq C_A$$

a monitoring signal indicating that at least the third capacitor bushing (2c) is not in proper state is generated;
- if the characteristic value comparisons have the result that

$$C'_c(t_n) - C_c < -C_C \text{ and } C'_a(t_n) - C_a > C_A \text{ and } \left|C'_b(t_n) - C_b\right| \leq C_B$$

a monitoring signal indicating that at least the first capacitor bushing (2a) is not in proper state is generated;
- otherwise a monitoring signal indicating that at least two of these capacitor bushings are not in proper state is generated.

**13.** Method according to claim 10 to 12 , wherein

- tolerance values CA > 0, CB > 0, CC > 0 for the characteristic value comparisons are determined;
- if the characteristic value comparisons have the result that

$$C'_a(t_n) - C_a > C_A \text{ and } C'_b(t_n) - C_b < -C_B \text{ and } \left|C'_c(t_n) - C_c\right| \leq C_C$$

a monitoring signal indicating that the first and third capacitor bushings (2a, 2c) are not in proper state and have a fault of the same kind is generated;
- if the characteristic value comparisons have the result that

$$C'_b(t_n) - C_b > C_B \text{ and } C'_c(t_n) - C_c < -C_C \text{ and } \left|C'_a(t_n) - C_a\right| \leq C_A$$

- a monitoring signal indicating that the second and first capacitor bushings (2b, 2a) are not in proper state and have a fault of the same kind is generated;
- if the characteristic value comparisons have the result that

$$C'_c(t_n) - C_c > C_C \text{ and } C'_a(t_n) - C_a < -C_A \text{ and } \left|C'_b(t_n) - C_b\right| \leq C_B$$

a monitoring signal indicating that the third and second capacitor bushings (2c, 2b) are not in proper state and have a fault of the same kind is generated.

**14.** Method according to claim 1 or any one of the other preceding claims, wherein

- at an intermediate instant (t1) before determination of the normalised characteristic value

• for each of these phases (A, B, C) the reference voltage is detected and a corresponding intermediate reference value is determined;
• these intermediate reference voltage values are compared with one another;
• determination of the normalised characteristic values is carried out if these comparisons have the result that these intermediate reference voltage values do not differ from one another by a more than a predetermined amount.

**15.** Method according to the preceding claim, wherein

- these voltage comparisons are carried out in such a way that

• tolerance values RAB > 0, RBC > 0, RCA > 0 are determined as the respective measure;
• it is checked whether

$$\left|R_a(t_1) - R_b(t_1)\right| \leq R_{AB}$$

and

$$\left|R_b(t_1) - R_c(t_1)\right| \leq R_{BC}$$

and

$$\left| R_c(t_1) - R_a(t_1) \right| \le R_{CA} \, ;$$

- $R_a(t1)$ is the intermediate reference voltage of the first phase;
- $R_b(t1)$ is the intermediate reference voltage of the second phase;
- $R_c(t1)$ is the intermediate reference voltage of the third phase.

16. Device (1) for monitoring capacitor bushings (2a, 2b, 2c) for an alternating current mains, wherein

- the alternating current mains has a first, second and third phase (A, B, C) and comprises:

• a first mains line (5a), with which the first phase (A) and a first capacitor bushing (2a) are associated and at which a first mains voltage is present,
• a second mains line (5b), with which the second phase (B) and a second capacitor bushing (2b) are associated and at which a second mains voltage is present,
• a third mains line (5c) with which the third phase (C) and a third capacitor bushing (2c) are associated and at which a third mains voltage is present;

- each of these capacitor bushings (2a, 2b, 2c) comprises:

• a conductor (4) connected with the associated mains line (5a, 5b, 5c),
• an electrically conductive foil (3) enclosing this conductor (4);

- the device (1) comprises:

• an evaluating device (8) coupled to the capacitor bushings (2a, 2b, 2c);

- the evaluating device (8) is so constructed that for each of these phases (A, B, C)

• at a predetermined initial instant (t0) for a characteristic variable, which is characteristic for the respective capacitor bushing (2a, 2b, 2c), it can determine a corresponding characteristic value **characterized in that** the evaluating device (8);
• at a predetermined later instant (tn) after the initial instant (t0) for the characteristic variable it can determine a corresponding normalised characteristic value in dependence on the respective characteristic value and/or on at least one of the remaining characteristic values of the remaining phases;
• at the initial instant (t0), a corresponding initial reference voltage value can be determined for a reference voltage;
• the determination of the normalised characteristic variable is additionally dependent on the respective initial reference voltage value and/or of at least one of the remaining initial reference voltage values of the remaining phases
• it can check whether the normalised characteristic value has impermissibly changed and

- the characteristic variable is the upper capacitance of a respective upper-voltage capacitor and/or the loss factor of the respective capacitor bushing, wherein the respective upper-voltage capacitor is formed by the respective foil and conductor.

17. Device (1) according to claim 16, comprising

- a first voltage converter (9a), which can be connected with the first mains line (5a);
- a second voltage converter (9b), which can be connected with the second mains line (5b);
- a third voltage converter (9c), which can be connected with the third mains line (5c);
- an evaluating device (8) coupled to the voltage converters (9a, 9b, 9c) and the measuring device (7);

wherein

- each of these voltage converters (9a, 9b, 9c) can detect the mains voltage for the respective phase (A, B, C);

- each reference voltage is the respective mains voltage;
- the evaluating device (8) can be constructed in such a way that for each of these phases (A, B, C)

• at the initial instant (t0) it can detect the mains voltage with the help of the respective voltage converter (9a, 9b, 9c) and can determine a corresponding initial mains voltage value;

- for each of these phases (A, B, C)

• the initial mains voltage value forms the respective initial reference voltage value.

18.  Device (1) according to claim 16, wherein

- a first parallel capacitor bushing (2a') is associated with the first mains line (5a);
- a second parallel capacitor bushing (2b') is associated with the second mains line (5b);
- a third parallel capacitor bushing (2c') is associated with the third mains line (5c);
- each of these parallel capacitor bushings (2a', 2b', 2c') comprises:

• a conductor (4) connected with the associated mains line (5a, 5b, 5c),
• an electrically conductive foil (3) enclosing this conductor (4);

- the device (1) comprises:

• a first parallel measuring adapter (6') which can be connected with the foil (3) of the first parallel capacitor bushing (2a');
• a second parallel measuring adapter (6') which can be connected with the foil (3) of the second parallel capacitor bushing (2b');
• a third parallel measuring adapter (6') which can be connected with the foil (3) of the third parallel capacitor bushing (2c');
• a measuring device (7) coupled to the parallel measuring adapter (6');

- the measuring device (7) for each of these phases (A, B, C) can detect a parallel foil voltage, which is present between the respective foil (3) and ground potential (13), with the help of the respective parallel measuring adapter (6');
- each reference voltage is the respective parallel foil voltage;
- the evaluating device (8) is so constructed that for each of these phases (A, B, C)

• at the initial instant (t0) it can detect the parallel foil voltage with the help of the measuring device (7) and can determine a corresponding initial foil voltage value;

- for each of these phase (A, B, C)

• the initial parallel foil voltage value forms the respective initial reference voltage value.

19.  Device (1) according to claim 16 or any of the two preceding claims, comprising:

- a first measuring adapter (6) which can be connected with the foil (3) of the first capacitor bushing (2a);
- a second measuring adapter (6) which can be connected with the foil (3) of the second capacitor bushing (2b);
- a third measuring adapter (6) which can be connected with the foil (3) of the third capacitor bushing (2c);
- a or the measuring device (7), which is coupled to the measuring adapter (6);

wherein

- the evaluating device (8) is coupled to the measuring device (7);
- the measuring device (7) for each of these phases (A, B, C) can detect a foil voltage, which is present between the respective foil (3) and ground potential (13), with the help of the respective measuring adapter (6);
- the evaluating device (8) is so constructed that for each of these phases (A, B, C)

• at the initial instant (t0) it can detect the foil voltage with the help of the measuring device (7) and can determine a corresponding initial foil voltage value;

- for each of these phases (A, B, C)

• determination of the normalised characteristic value additionally depends on the respective initial foil voltage value and/or on at least one of the remaining initial foil voltage values.

**20.** Device (1) according to claim 16 or any one of the 3 preceding device claims, wherein

- for each of these phases (A, B, C)

• an outer capacitor (La, Lb, Lc) is formed by the respective foil (3) and ground potential;
• a lower-voltage capacitor (Ja, Jb, Jc) is formed by a parallel circuit comprising the measuring device (7) and the respective outer capacitor (La, Lb, Lc);

- the evaluating device (8) is so constructed that for each of these phases (A, B, C)

• at the initial instant (t0) for the lower capacitance of the lower-voltage capacitor it can determine a corresponding lower capacitance value;

- for each of these phases (A, B, C)

• determination of the normalised characteristic value additionally depends on the respective lower capacitance value and/or on at least one of the remaining lower capacitance values.

**21.** Device (1) according to claim 19, wherein

- for each of these phases (A, B, C)

• an upper-voltage capacitor (Ka, Kb, Kc) is formed by the respective foil (3) and conductor (4);
• the respective characteristic variable is the upper capacitance of the respective upper-voltage capacitor and the respective characteristic value is a corresponding upper capacitance value;

- the evaluating device (8) is so constructed that at the later instant (tn) for each of these phases (A, B, C) it

• can detect the foil voltage and can determine a corresponding later foil voltage value;

- the evaluating device (8) is so constructed that it can calculate the normalised upper capacitance value of the first capacitor bushing (2a) in accordance with the following equation:

$$C'_a(t_n) = B_a \cdot \frac{V_a(t_n) \cdot N_a \cdot K_a}{V_b(t_n) \cdot N_b \cdot \left(\frac{B_b}{C_b}+1\right) - V_a(t_n) \cdot N_a \cdot K_a}$$

wherein

$$N_a = \frac{R_a(t_0)}{V_a(t_0)} \cdot \frac{C_a}{B_a + C_a}$$

wherein Ka is a predetermined constant or variable first correction value;
and/or
- the evaluating device (8) is so constructed that it calculates the normalised upper capacitance value of the second capacitor bushing (2b) in accordance with the following equation:

$$C'_b(t_n) = B_b \cdot \frac{V_b(t_n) \cdot N_b \cdot K_b}{V_c(t_n) \cdot N_c \cdot \left(\dfrac{B_c}{C_c}+1\right) - V_b(t_n) \cdot N_b \cdot K_a}$$

wherein

$$N_b = \frac{R_b(t_0)}{V_b(t_0)} \cdot \frac{C_b}{B_b + C_b}$$

wherein Kb is a predetermined constant or variable second correction value; and/or
- the evaluating device (8) is so constructed that it calculates the normalised upper capacitance value of the third capacitance bushing (2c) in accordance with the following equation:

$$C'_c(t_n) = B_c \cdot \frac{V_c(t_n) \cdot N_c \cdot K_c}{V_a(t_n) \cdot N_a \cdot \left(\dfrac{B_a}{C_a}+1\right) - V_c(t_n) \cdot N_c \cdot K_c}$$

wherein

$$N_c = \frac{R_c(t_0)}{V_c(t_0)} \cdot \frac{C_c}{B_c + C_c}$$

wherein Kc is a predetermined constant or variable third correction value;
- Ba, Bb and Bc are the first, second and third lower capacitance values;
- Ca, Cb and Cc are the first, second and third upper capacitance values;
- Ra(t0), Rb(t0) and Rc(t0) are the first, second and third initial reference voltage values;
- Va(tn), Vb(tn) and Vc(tn) are the first, second and third later foil voltage values.

**22.** Device (1) according to claim 18 or 19, wherein

- the measuring device (7) comprises:

• a first measuring capacitor connected with the first measuring adapter (6);
• a second measuring capacitor connected with the second measuring adapter (6);
• a third measuring capacitor connected with the third measuring adapter (6);

- the capacitances of these three measuring capacitors are different;
- the three capacitances are in the ratio of 1:2:3 or 1:2:4 or 1:2:5 or 1:3:5 or 1:3:7 or 1:3:9 or 1:4:7 or 1:4:9 to one another.

**Revendications**

**1.** Procédé de surveillance de traversées à condensateur (2a, 2b, 2c) pour un réseau de courant alternatif,

- le réseau de courant alternatif possédant une première, une deuxième et une troisième phase (A, B, C) et comprenant :

* une première ligne de réseau (5a), qui est associée à la première phase (A) et à une première traversée à condensateur (2a) et sur laquelle une première tension de réseau est présente,

* une deuxième ligne de réseau (5b), qui est associée à la deuxième phase (B) et à une deuxième traversée à condensateur (2b) et sur laquelle une deuxième tension de réseau est présente ;
* une troisième ligne de réseau (5c), qui est associée à la troisième phase (C) et à une troisième traversée à condensateur (2c) et sur laquelle une deuxième tension de réseau est présente,

- chacune de ces traversées à condensateur (2a, 2b, 2c) comportant :

* un conducteur (4), qui est relié à la ligne de réseau (5a, 5b, 5c) associée,
* un revêtement (3) électriquement conducteur, qui entoure ce conducteur (4) ;

- pour chacune de ces phases (A, B, C)

* une valeur caractéristique correspondante étant identifiée à un instant initial (t0) prédéterminé pour une grandeur caractéristique, qui est caractéristique pour la traversée à condensateur (2a, 2b, 2c) respective ;
**caractérisé en ce que**
* une valeur caractéristique normalisée correspondante est identifiée pour la grandeur caractéristique à un instant ultérieur (tn) prédéterminé après l'instant initial (t0) en fonction de la valeur caractéristique respective et/ou d'au moins l'une des autres valeurs caractéristiques des phases restantes ;
* une valeur de tension de référence initiale correspondante est identifiée à l'instant initial (t0) pour une tension de référence ;
* l'identification de la valeur caractéristique normalisée dépend en plus de la valeur de tension de référence initiale correspondante respective et/ou d'au moins l'une des autres valeurs de tension de référence initiales des phases restantes ;
* un contrôle est effectué afin de vérifier si la valeur caractéristique normalisée a varié de manière non admissible et

- la grandeur caractéristique est la capacité supérieure d'un condensateur à tension supérieure respectif et/ou le facteur de perte de la traversée à condensateur respective, le condensateur à tension supérieure respectif étant formé par le revêtement et le conducteur respectifs.

2. Procédé selon la revendication 1,

- chaque tension de référence dépendant de la tension de réseau respective.

3. Procédé selon la revendication 2,

- chaque tension de référence étant la tension de réseau respective ;
- pour chacune de ces phases (A, B, C)

* la tension de réseau étant acquise et une valeur de tension de réseau initiale correspondante étant identifiée à l'instant initial (t0) ;
* la valeur de tension de réseau initiale formant la valeur de tension de référence initiale respective.

4. Procédé selon la revendication 2,

- une première traversée à condensateur parallèle (2a') étant associée à la première ligne de réseau (5a) ;
- une deuxième traversée à condensateur parallèle (2b') étant associée à la deuxième ligne de réseau (5b) ;
- une troisième traversée à condensateur parallèle (2c') étant associée à la troisième ligne de réseau (5c) ;
- chacune de ces traversées à condensateur parallèles (2a', 2b', 2c') comportant :

* un conducteur (4) qui est relié à la ligne de réseau (5a, 5b, 5c) associée,
* un revêtement (3) électriquement conducteur, qui entoure ce conducteur (4) ;

- chaque tension de référence étant une tension de revêtement parallèle qui est présente entre le revêtement (3) et le potentiel de masse (13) de la traversée à condensateur parallèle respective ;
- pour chacune de ces phases (A, B, C)

* la tension de revêtement parallèle étant acquise et une valeur de tension de revêtement parallèle initiale correspondante étant identifiée à l'instant initial (t0) ;
* la valeur de tension de revêtement parallèle initiale formant la valeur de tension de référence initiale respective.

5. Procédé selon la revendication 1 ou l'une des revendications précédentes,

   - pour chacune de ces phases (A, B, C)
   * la tension de référence étant une tension constante pour laquelle est prédéterminée une valeur de tension constante correspondante.

6. Procédé selon la revendication 1 ou l'une des revendications précédentes,

   - pour chacune de ces phases (A, B, C)

     * une tension de revêtement, laquelle est présente entre le revêtement (3) respectif et le potentiel de masse (13), étant acquise à l'instant initial (t0) et une valeur de tension de revêtement initiale correspondante étant identifiée ;
     * l'identification de la valeur caractéristique normalisée dépendant de la valeur de tension de revêtement initiale respective et/ou d'au moins l'une des autres valeurs de tension de revêtement initiales.

7. Procédé selon la revendication 1 ou l'une des revendications précédentes,

   - un dispositif de mesure (7) est couplé à ces revêtements (3) et peut acquérir, pour chacune de ces phases (A, B, C), une tension de revêtement qui est présente entre le revêtement (3) correspondant et le potentiel de masse (13) ;
   - pour chacune de ces phases (A, B, C)

     * un condensateur externe (La, Lb, Lc) étant formé par le revêtement (3) respectif et le potentiel de masse (13) ;
     * un condensateur à tension inférieure (Ja, Jb, Jb) étant formé par un circuit parallèle qui comprend le dispositif de mesure (7) et le condensateur externe ;
     * une valeur de capacité inférieure correspondante étant identifiée à ou pour l'instant initial (t0) pour la capacité inférieure du condensateur à tension inférieure ;
     * l'identification de la valeur caractéristique normalisée dépendant en plus de la valeur de capacité inférieure respective et/ou d'au moins l'une des autres valeurs de capacité inférieure.

8. Procédé selon la revendication 7,

   - pour chacune de ces phases (A, B, C)

     * un condensateur à tension supérieure (Ka, Kb, Kc) étant formé par le revêtement (3) respectif et le conducteur (4) ;
     * la grandeur caractéristique respective étant la capacité supérieure du condensateur à tension supérieure respectif et la valeur caractéristique respective une valeur de capacité supérieure correspondante ;

   - à l'instant ultérieur (tn), pour chacune de ces phases (A, B, C) * la tension de revêtement étant acquise et une valeur de tension de revêtement ultérieure correspondante étant identifiée ;
   - la valeur de capacité supérieure normalisée de la première traversée à condensateur (2a) étant calculée conformément à la formule suivante :

$$C'_a(t_n) = B_a \cdot \frac{V_a(t_n) \cdot N_a \cdot K_a}{V_b(t_n) \cdot N_b \cdot \left(\frac{B_b}{C_b} + 1\right) - V_a(t_n) \cdot N_a \cdot K_a}$$

avec

$$N_a = \frac{R_a(t_0)}{V_a(t_0)} \cdot \frac{C_a}{B_a + C_a}$$

où Ka est une première valeur de correction constante ou variable ; et/ou
- la valeur de capacité supérieure normalisée de la deuxième traversée à condensateur (2b) étant calculée conformément à la formule suivante :

$$C'_b(t_n) = B_b \cdot \frac{V_b(t_n) \cdot N_b \cdot K_b}{V_c(t_n) \cdot N_c \cdot \left(\frac{B_c}{C_c} + 1\right) - V_b(t_n) \cdot N_b \cdot K_b}$$

avec

$$N_b = \frac{R_b(t_0)}{V_b(t_0)} \cdot \frac{C_b}{B_b + C_b}$$

où Kb est une deuxième valeur de correction constante ou variable ; et/ou
- la valeur de capacité supérieure normalisée de la troisième traversée à condensateur (2b) étant calculée conformément à la formule suivante :

$$C'_c(t_n) = B_c \cdot \frac{V_c(t_n) \cdot N_c \cdot K_c}{V_a(t_n) \cdot N_a \cdot \left(\frac{B_a}{C_a} + 1\right) - V_c(t_n) \cdot N_c \cdot K_c}$$

avec

$$N_c = \frac{R_c(t_0)}{V_c(t_0)} \cdot \frac{C_c}{B_c + C_c}$$

où Kc est une troisième valeur de correction constante ou variable ;
- Ba, Bb et Bc étant la première, la deuxième et la troisième valeur de capacité inférieure ;
- Ca, Cb et Cc étant la première, la deuxième et la troisième valeur de capacité supérieure ;
- Ra(t0), Rb(t0) et Rc(t0) étant la première, la deuxième et la troisième valeur de tension de référence initiale ;
- Va(tn), Vb(tn) et Vc(tn) étant la première, la deuxième et la troisième valeur de tension de revêtement ultérieure.

**9.** Procédé selon la revendication précédente,

- Ka = 1 étant vérifiée ; ou
- Ka = Rb(tn)/Ra(tn) étant vérifiée, où

\* Ra(tn) est une première valeur de tension de référence ultérieure, laquelle est identifiée à l'instant ultérieur (tn) pour une première tension de référence qui est associée à la première phase (A) ;
\* Rb(tn) est une deuxième valeur de tension de référence ultérieure, laquelle est identifiée à cet instant ultérieur (tn) pour une deuxième tension de référence qui est associée à la deuxième phase (B), voisine de la première phase (A) ;
et/ou

- Kb = 1 étant vérifiée ; ou
- Kb = Rc(tn)/Rb(tn) étant vérifiée, où

\* Rb(tn) est une deuxième valeur de tension de référence ultérieure, laquelle est identifiée à l'instant ultérieur (tn) pour une deuxième tension de référence qui est associée à la deuxième phase (A) ;
\* Rc(tn) est une troisième valeur de tension de référence ultérieure, laquelle est identifiée à cet instant ultérieur (tn) pour une troisième tension de référence qui est associée à la troisième phase (C), voisine de la deuxième phase (B) ;
et/ou

- Kc = 1 étant vérifiée ; ou
- Kc = Ra(tn)/Rc(tn) étant vérifiée, où

   * Rc(tn) est une troisième valeur de tension de référence ultérieure, laquelle est identifiée à l'instant ultérieur (tn) pour une troisième tension de référence qui est associée à la troisième phase (B) ;
   * Ra(tn) est une première valeur de tension de référence ultérieure, laquelle est identifiée à cet instant ultérieur (tn) pour une première tension de référence qui est associée à la première phase (A), voisine de la troisième phase (C).

**10.** Procédé selon la revendication 1 ou l'une des revendications précédentes,

- la valeur caractéristique normalisée étant comparée à la valeur caractéristique respective lors du contrôle.

**11.** Procédé selon la revendication précédente,

- des valeurs de tolérance CA > 0, CB > 0, CC > 0 étant déterminées pour les comparaisons de valeurs caractéristiques ;
- dans le cas où les comparaisons de valeurs caractéristiques ont pour résultat que

$$|C'_a(t_n) - C_a| \leq C_A \text{ et } |C'_b(t_n) - C_b| \leq C_B \text{ et } |C'_c(t_n) - C_c| \leq C_C$$

sont vérifiées, alors un signal de surveillance étant généré, lequel indique que les traversées à condensateur (2a, 2b, 2c) sont en état conforme.

**12.** Procédé selon la revendication 10 ou 11,

- des valeurs de tolérance CA > 0, CB > 0, CC > 0 étant déterminées pour les comparaisons de valeurs caractéristiques ;
- dans le cas où les comparaisons de valeurs caractéristiques ont pour résultat que

$$C'_a(t_n) - C_a < -C_A \text{ et } C'_b(t_n) - C_b > C_B \text{ et } |C'_c(t_n) - C_c| \leq C_C$$

sont vérifiées, alors un signal de surveillance étant généré, lequel indique qu'au moins la deuxième traversée à condensateur (2b) n'est pas en état conforme ;
- dans le cas où les comparaisons de valeurs caractéristiques ont pour résultat que

$$C'_b(t_n) - C_b < -C_B \text{ et } C'_c(t_n) - C_c > C_C \text{ et } |C'_a(t_n) - C_a| \leq C_A$$

sont vérifiées, alors un signal de surveillance étant généré, lequel indique qu'au moins la troisième traversée à condensateur (2c) n'est pas en état conforme ;
- dans le cas où les comparaisons de valeurs caractéristiques ont pour résultat que

$$C'_c(t_n) - C_c < -C_C \text{ et } C'_a(t_n) - C_a > C_A \text{ et } |C'_b(t_n) - C_b| \leq C_B$$

sont vérifiées, alors un signal de surveillance étant généré, lequel indique qu'au moins la première traversée à condensateur (2a) n'est pas en état conforme ;
- dans le cas contraire, un signal de surveillance étant généré, lequel indique qu'au moins deux de ces traversées à condensateur ne sont pas en état conforme.

**13.** Procédé selon les revendications 10 à 12,

- des valeurs de tolérance CA > 0, CB > 0, CC > 0 étant déterminées pour les comparaisons de valeurs caractéristiques ;
- dans le cas où les comparaisons de valeurs caractéristiques ont pour résultat que

$$C'_a(t_n) - C_a > C_A \quad \text{et} \quad C'_b(t_n) - C_b < -C_B \quad \text{et} \quad |C'_c(t_n) - C_c| \leq C_C$$

sont vérifiées, alors un signal de surveillance étant généré, lequel indique que la première et la troisième traversée à condensateur (2a, 2c) ne sont pas en état conforme et présentent un défaut identique ;
- dans le cas où les comparaisons de valeurs caractéristiques ont pour résultat que

$$C'_b(t_n) - C_b > C_B \quad \text{et} \quad C'_c(t_n) - C_c < -C_C \quad \text{et} \quad |C'_a(t_n) - C_a| \leq C_A$$

sont vérifiées, alors un signal de surveillance étant généré, lequel indique que la deuxième et la première traversée à condensateur (2b, 2a) ne sont pas en état conforme et présentent un défaut identique ;
- dans le cas où les comparaisons de valeurs caractéristiques ont pour résultat que

$$C'_c(t_n) - C_c > C_C \quad \text{et} \quad C'_a(t_n) - C_a < -C_A \quad \text{et} \quad |C'_b(t_n) - C_b| \leq C_B$$

sont vérifiées, alors un signal de surveillance étant généré, lequel indique que la troisième et la deuxième traversée à condensateur (2c, 2b) ne sont pas en état conforme et présentent un défaut identique.

**14.** Procédé selon la revendication 1 ou l'une des revendications précédentes,

- à un instant intermédiaire (t1), avant l'identification de la valeur caractéristique normalisée,

* pour chacune de ces phases (A, B, C), la tension de référence est acquise et une valeur de tension de référence intermédiaire correspondante est identifiée ;
* ces valeurs de tension de référence intermédiaires sont comparées entre elles ;
* l'identification des valeurs caractéristiques normalisées est effectuée dans le cas où ces comparaisons ont pour résultat que ces valeurs de tension de référence intermédiaires ne s'écartent pas de plus d'une cote prédéterminée l'une de l'autre.

**15.** Procédé selon la revendication précédente,

- ces comparaisons de tensions sont effectuées de telle sorte que

* des valeurs de tolérance RAB > 0, RBC > 0, RCA > 0 sont déterminées en tant que la cote respective ;
* un contrôle est effectué pour vérifier si

$$|R_a(t_1) - R_b(t_1)| \leq R_{AB}$$

et

$$|R_b(t_1) - R_c(t_1)| \leq R_{BC}$$

et

$$|R_c(t_1) - R_a(t_1)| \leq R_{CA}$$

sont vérifiées ;

- Ra(t1) étant la valeur de tension de référence intermédiaire de la première phase ;

- Rb(t1) étant la valeur de tension de référence intermédiaire de la deuxième phase ;
- Rc(t1) étant la valeur de tension de référence intermédiaire de la troisième phase.

**16.** Arrangement (1) servant à la surveillance de traversées à condensateur (2a, 2b, 2c) pour un réseau de courant alternatif,

- le réseau de courant alternatif possédant une première, une deuxième et une troisième phase (A, B, C) et comprenant :

    * une première ligne de réseau (5a), qui est associée à la première phase (A) et à une première traversée à condensateur (2a) et sur laquelle une première tension de réseau est présente,
    * une deuxième ligne de réseau (5b), qui est associée à la deuxième phase (B) et à une deuxième traversée à condensateur (2b) et sur laquelle une deuxième tension de réseau est présente ;
    * une troisième ligne de réseau (5c), qui est associée à la troisième phase (C) et à une troisième traversée à condensateur (2c) et sur laquelle une deuxième tension de réseau est présente,

- chacune de ces traversées à condensateur (2a, 2b, 2c) comportant :

    * un conducteur (4), qui est relié à la ligne de réseau (5a, 5b, 5c) associée,
    * un revêtement (3) électriquement conducteur, qui entoure ce conducteur (4) ;

- l'arrangement (1) comportant :

    * un dispositif d'interprétation (8) qui est couplé aux traversées à condensateur (2a, 2b, 2c) ;

- le dispositif d'interprétation (8) étant configuré de telle sorte que pour chacune de ces phases (A, B, C)

    * il peut identifier une valeur caractéristique correspondante à un instant initial (t0) prédéterminé pour une grandeur caractéristique, qui est caractéristique pour la traversée à condensateur (2a, 2b, 2c) respective ; **caractérisé en ce que** le dispositif d'interprétation (8)
    * peut identifier une valeur caractéristique normalisée correspondante pour la grandeur caractéristique à un ou à l'instant ultérieur (tn) prédéterminé après l'instant initial (t0) en fonction de la valeur caractéristique respective et/ou d'au moins l'une des autres valeurs caractéristiques des phases restantes ;
    * peut identifier une valeur de tension de référence initiale correspondante à l'instant initial (t0) pour une tension de référence ;
    * l'identification de la valeur caractéristique normalisée dépend en plus de la valeur de tension de référence initiale correspondante respective et/ou d'au moins l'une des autres valeurs de tension de référence initiales ;
    * peut vérifier si la valeur caractéristique normalisée a varié de manière non admissible et

- la grandeur caractéristique est la capacité supérieure d'un condensateur à tension supérieure respectif et/ou le facteur de perte de la traversée à condensateur respective, le condensateur à tension supérieure respectif étant formé par le revêtement et le conducteur respectifs.

**17.** Arrangement (1) selon la revendication 16, comportant

- un premier convertisseur de tension (9a) qui peut être relié à la première ligne de réseau (5a) ;
- un deuxième convertisseur de tension (9b) qui peut être relié à la deuxième ligne de réseau (5b) ;
- un troisième convertisseur de tension (9c) qui peut être relié à la troisième ligne de réseau (5c) ;
- un dispositif d'interprétation (8) qui est couplé aux convertisseurs de tension (9a, 9b, 9c) et au dispositif de mesure (7) ;
- chacun de ces convertisseurs de tension (9a, 9b, 9c) pouvant acquérir la tension de réseau pour la phase (A, B, C) respective ;
- chaque tension de référence étant la tension de réseau respective ;
- le dispositif d'interprétation (8) étant configuré de telle sorte que pour chacune de ces phases (A, B, C), il
    * peut acquérir la tension de réseau à l'aide du convertisseur de tension (9a, 9b, 9c) respectif à l'instant initial (t0) et identifier une valeur de tension de réseau initiale correspondante ;
- pour chacune de ces phases (A, B, C),
    * la valeur de tension de réseau initiale forme la valeur de tension de référence initiale respective.

**18.** Arrangement (1) selon la revendication 16,

- une première traversée à condensateur parallèle (2a') étant associée à la première ligne de réseau (5a) ;
- une deuxième traversée à condensateur parallèle (2b') étant associée à la deuxième ligne de réseau (5b) ;
- une troisième traversée à condensateur parallèle (2c') étant associée à la troisième ligne de réseau (5c) ;
- chacune de ces traversées à condensateur parallèles (2a', 2b', 2c') comportant :

  * un conducteur (4) qui est relié à la ligne de réseau (5a, 5b, 5c) associée,
  * un revêtement (3) électriquement conducteur, qui entoure ce conducteur (4) ;

- l'arrangement (1) comportant :

  * un premier adaptateur de mesure parallèle (6'), qui peut être relié au revêtement (3) de la première traversée à condensateur parallèle (2a') ;
  * un deuxième adaptateur de mesure parallèle (6'), qui peut être relié au revêtement (3) de la deuxième traversée à condensateur parallèle (2b') ;
  * un troisième adaptateur de mesure parallèle (6'), qui peut être relié au revêtement (3) de la troisième traversée à condensateur parallèle (2c') ;
  * un dispositif de mesure (7) qui est couplé aux adaptateurs de mesure parallèles (6') ;

- le dispositif de mesure (7), pour chacune de ces phases (A, B, C), pouvant acquérir une tension de revêtement parallèle, laquelle est présente entre le revêtement (3) respectif et le potentiel de masse (13), à l'aide de l'adaptateur de mesure parallèle (6') respectif ;
- chaque tension de référence étant la tension de revêtement parallèle respective ;
- le dispositif d'interprétation (8) étant configuré de telle sorte que pour chacune de ces phases (A, B, C), il
* peut acquérir la tension de revêtement parallèle à l'aide du dispositif de mesure (7) à l'instant initial (t0) et identifier une valeur de tension de revêtement initiale correspondante ;
- pour chacune de ces phases (A, B, C),
* la valeur de tension de revêtement parallèle initiale formant la valeur de tension de référence initiale respective.

**19.** Arrangement (1) selon la revendication 16 ou l'une des 2 revendications précédentes, comportant

- un premier adaptateur de mesure (6), qui peut être relié au revêtement (3) de la première traversée à condensateur (2a) ;
- un deuxième adaptateur de mesure (6), qui peut être relié au revêtement (3) de la deuxième traversée à condensateur (2b) ;
- un troisième adaptateur de mesure (6), qui peut être relié au revêtement (3) de la troisième traversée à condensateur (2c) ;
- un ou le dispositif de mesure (7) qui est couplé aux adaptateurs de mesure (6) ;
- le dispositif d'interprétation (8) étant couplé au dispositif de mesure (7) ;
- le dispositif de mesure (7), pour chacune de ces phases (A, B, C), pouvant acquérir une tension de revêtement, laquelle est présente entre le revêtement (3) respectif et le potentiel de masse (13), à l'aide de l'adaptateur de mesure (6) respectif ;
- le dispositif d'interprétation (8) étant configuré de telle sorte que pour chacune de ces phases (A, B, C), il
* peut acquérir la tension de revêtement à l'aide du dispositif de mesure (7) à l'instant initial (t0) et identifier une valeur de tension de revêtement initiale correspondante ;
- pour chacune de ces phases (A, B, C),
* l'identification de la valeur caractéristique normalisée dépendant en pus de la valeur de tension de revêtement initiale respective et/ou d'au moins l'une des autres valeurs de tension de revêtement initiales.

**20.** Arrangement (1) selon la revendication 16 ou l'une des 3 revendications précédentes,

- pour chacune de ces phases (A, B, C)

  * un condensateur externe (La, Lb, Lc) étant formé par le revêtement (3) respectif et le potentiel de masse (13) ;
  * un condensateur à tension inférieure (Ja, Jb, Jb) étant formé par un circuit parallèle qui comprend le dispositif de mesure (7) et le condensateur externe (La, Lb, Lc) respectif ;

- le dispositif d'interprétation (8) étant configuré de telle sorte que pour chacune de ces phases (A, B, C), il
* peut identifier une valeur de capacité inférieure correspondante à l'instant initial (t0) pour la capacité inférieure du condensateur à tension inférieure ;
- pour chacune de ces phases (A, B, C),
* l'identification de la valeur caractéristique normalisée dépendant en plus de la valeur de capacité inférieure respective et/ou d'au moins l'une des autres valeurs de capacité inférieure.

**21.** Arrangement (1) selon la revendication 19,

- pour chacune de ces phases (A, B, C)

* un condensateur à tension supérieure (Ka, Kb, Kc) étant formé par le revêtement (3) respectif et le conducteur (4) ;
* la grandeur caractéristique respective étant la capacité supérieure du condensateur à tension supérieure respectif et la valeur caractéristique respective une valeur de capacité supérieure correspondante ;

- le dispositif d'interprétation (8) étant configuré de telle sorte qu'à l'instant ultérieur (tn), pour chacune de ces phases (A, B, C), il
* peut acquérir la tension de revêtement et une identifier une valeur de tension de revêtement ultérieure correspondante ;
- le dispositif d'interprétation (8) étant configuré de telle sorte qu'il calcule la valeur de capacité supérieure normalisée de la première traversée à condensateur (2a) conformément à la formule suivante :

$$C'_a(t_n) = B_a \cdot \frac{V_a(t_n) \cdot N_a \cdot K_a}{V_b(t_n) \cdot N_b \cdot \left(\frac{B_b}{C_b} + 1\right) - V_a(t_n) \cdot N_a \cdot K_a}$$

avec

$$N_a = \frac{R_a(t_0)}{V_a(t_0)} \cdot \frac{C_a}{B_a + C_a}$$

où Ka est une première valeur de correction constante ou variable ; et/ou
- le dispositif d'interprétation (8) étant configuré de telle sorte qu'il calcule la valeur de capacité supérieure normalisée de la deuxième traversée à condensateur (2b) conformément à la formule suivante :

$$C'_b(t_n) = B_b \cdot \frac{V_b(t_n) \cdot N_b \cdot K_b}{V_c(t_n) \cdot N_c \cdot \left(\frac{B_c}{C_c} + 1\right) - V_b(t_n) \cdot N_b \cdot K_a}$$

avec

$$N_b = \frac{R_b(t_0)}{V_b(t_0)} \cdot \frac{C_b}{B_b + C_b}$$

où Kb est une deuxième valeur de correction constante ou variable ; et/ou
- le dispositif d'interprétation (8) étant configuré de telle sorte qu'il calcule la valeur de capacité supérieure normalisée de la troisième traversée à condensateur (2b) conformément à la formule suivante :

$$C'_c(t_n) = B_c \cdot \frac{V_c(t_n) \cdot N_c \cdot K_c}{V_a(t_n) \cdot N_a \cdot \left(\frac{B_a}{C_a} + 1\right) - V_c(t_n) \cdot N_c \cdot K_c}$$

avec

$$N_c = \frac{R_c(t_0)}{V_c(t_0)} \cdot \frac{C_c}{B_c + C_c}$$

où Kc est une troisième valeur de correction constante ou variable ;
- Ba, Bb et Bc étant la première, la deuxième et la troisième valeur de capacité inférieure ;
- Ca, Cb et Cc étant la première, la deuxième et la troisième valeur de capacité supérieure ;
- Ra(t0), Rb(t0) et Rc(t0) étant la première, la deuxième et la troisième valeur de tension de référence initiale ;
- Va(tn), Vb(tn) et Vc(tn) étant la première, la deuxième et la troisième valeur de tension de revêtement ultérieure.

22. Arrangement (1) selon les revendications précédentes 18 ou 19,

- le dispositif de mesure (7) comportant :

* un premier condensateur de mesure qui est raccordé au premier adaptateur de mesure (6) ;
* un deuxième condensateur de mesure qui est raccordé au deuxième adaptateur de mesure (6) ;
* un troisième condensateur de mesure qui est raccordé au troisième adaptateur de mesure (6) ;

- les capacités de ces trois condensateurs de mesure étant différentes ;
- les trois capacités se trouvant dans un rapport 1:2:3 ou 1:2:4 ou 1:2:5 ou 1:3:5 ou 1:3:7 ou 1:3:9 ou 1:4:7 ou 1:4:9 entre elles.

**FIG. 1**

FIG. 2

## FIG. 3

## FIG. 4

## FIG. 5

**FIG. 6**

EP 3 589 963 B1

**IN DER BESCHREIBUNG AUFGEFÜHRTE DOKUMENTE**

**In der Beschreibung aufgeführte Patentdokumente**

- DE 19519230 C1
- DE 10037432 A1
- DE 3601934 C2
- US 4757263 A
- WO 2015071253 A1